(19) Europäisches Patentamt
European Patent Office
Office européen des brevets

(11) **EP 4 316 814 A1**

(12) **EUROPEAN PATENT APPLICATION**
published in accordance with Art. 153(4) EPC


(43) Date of publication:
**07.02.2024 Bulletin 2024/06**

(21) Application number: **22780310.3**

(22) Date of filing: **22.03.2022**

(51) International Patent Classification (IPC):
***B32B 27/00*** *(2006.01)* ***C08F 299/02*** *(2006.01)*
***C08G 65/40*** *(2006.01)* ***C08G 73/10*** *(2006.01)*
***C08L 71/00*** *(2006.01)* ***G03F 7/027*** *(2006.01)*

(52) Cooperative Patent Classification (CPC):
**B32B 27/00; C08F 299/02; C08G 65/40; C08G 73/10; C08L 71/00; G03F 7/027; G03F 7/20**

(86) International application number:
**PCT/JP2022/013158**

(87) International publication number:
**WO 2022/210095 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.04.2021 JP 2021063606**
**02.04.2021 JP 2021063607**



(71) Applicant: **JSR Corporation**
**Tokyo 105-8640 (JP)**

(72) Inventors:
- **KAWASHIMA Naoyuki**
**Tokyo 105-8640 (JP)**
- **YAMASHITA Yuutoku**
**Tokyo 105-8640 (JP)**
- **ANABUKI Shoma**
**Tokyo 105-8640 (JP)**
- **KAMEYAMA Takeru**
**Tokyo 105-8640 (JP)**
- **NISHINO Kenta**
**Tokyo 105-8640 (JP)**
- **SHINOHARA Arata**
**Tokyo 105-8640 (JP)**
- **FUJITOMI Shintarou**
**Tokyo 105-8640 (JP)**

(74) Representative: **TBK**
**Bavariaring 4-6**
**80336 München (DE)**


(54) **POLYMER, COMPOSITION, CURED PRODUCT, MULTILAYER BODY, AND ELECTRONIC COMPONENT**


(57) One embodiment of the present invention relates to a polymer, a composition, a cured product, a laminate, or an electronic component, and the polymer has a repeating structural unit represented by Formula (1) and has a group Y represented by Formula (a) at a terminal:

$$-\!\!\left[-R^2-X-R^1-X-\right]\!\!- \qquad (1)$$

wherein X's are each independently -O-, -S-, or - N($R^3$)-, $R^3$ is a hydrogen atom, a monovalent hydrocarbon group having 1 to 20 carbon atoms, a monovalent halogenated hydrocarbon group having 1 to 20 carbon atoms, or a group obtained by substituting a part of the hydrocarbon group or the halogenated hydrocarbon group with at least one selected from an oxygen atom and a sulfur atom, $R^1$ is a divalent organic group, and $R^2$ is a divalent unsubstituted or substituted nitrogen-containing heteroaromatic ring;

-Y (a)


EP 4 316 814 A1

wherein Y is a group containing an ethylenically unsaturated double bond and having 3 to 50 carbon atoms, an unsubstituted or substituted aromatic hydrocarbon group having 6 to 50 carbon atoms, an unsubstituted or substituted aliphatic hydrocarbon group having 6 to 50 carbon atoms, or an unsubstituted nitrogen-containing heteroaromatic ring, and when the aromatic hydrocarbon group or the aliphatic hydrocarbon group has a substituent, the substituent is a group other than a hydroxy group.

## Description

### Technical Field

One embodiment of the present invention relates to a polymer, a composition, a cured product, a laminate, or an electronic component.

### Background Art

In recent years, in the field of information communication, a signal band of an information communication device has been increased in frequency for the purpose of high-speed and large-capacity transmission. In order to cope with this high frequency, there is an increasing demand for a low dielectric-low loss tangent material for an insulator used for a printed wiring board or a semiconductor package.

As a material corresponding to the high frequency, for example, a polyolefin resin, a styrene resin, a fluororesin, a polyphenylene ether resin, a vinyl benzyl ether resin, or a composition using a polyphenylene ether resin has been proposed (Patent Literatures 1 to 6).

### Citation List

### Patent Literature

Patent Literature 1: JP H07-188362 A
Patent Literature 2: JP 2004-83680 A
Patent Literature 3: JP 3414556 B2
Patent Literature 4: JP 2003-306591 A
Patent Literature 5: JP 5649773 B2
Patent Literature 6: JP 2017-200997 A

### Summary of Invention

### Technical Problem

However, the conventional materials such as the compositions described in Patent Literatures 1 to 6 are excellent in low dielectric-low loss tangent to some extent, but do not necessarily satisfy all requirements for properties required for electronic materials such as heat resistance, chemical resistance, and adhesiveness.

For example, a composition using a polyphenylene ether resin and a fluororesin are excellent in low dielectric-low loss tangent and heat resistance, but do not have sufficient adhesiveness to a copper foil with low roughness, and the composition described in Patent Literature 6 has room for improvement in terms of chemical resistance and low dielectric properties.

One embodiment of the present invention provides a polymer that has a low dielectric constant and a low loss tangent, and provides a composition and a laminate that have a low dielectric constant and a low loss tangent and are excellent in curability, adhesiveness, and heat resistance in a well-balanced manner.

### Solution to Problem

The present inventors have conducted intensive studies in order to solve the above problems, and as a result, have found that the above problems can be solved by the following configuration examples.

The configuration examples of the present invention are as follows.

[1] A polymer having:

a repeating structural unit represented by the following Formula (1); and
a group Y represented by the following Formula (a) at a terminal.

[Chem. 1]

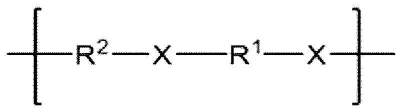

(1)

[wherein X's are each independently -O-, -S-, or - $N(R^3)$-, $R^3$ is a hydrogen atom, a monovalent hydrocarbon group having 1 to 20 carbon atoms, a monovalent halogenated hydrocarbon group having 1 to 20 carbon atoms, or a group obtained by substituting a part of the hydrocarbon group or the halogenated hydrocarbon group with at least one selected from an oxygen atom and a sulfur atom, $R^1$ is a divalent organic group, and $R^2$ is a divalent unsubstituted or substituted nitrogen-containing heteroaromatic ring.]

[Chem. 2]

-Y (a)

[wherein Y is a group containing an ethylenically unsaturated double bond and having 3 to 50 carbon atoms, an unsubstituted or substituted aromatic hydrocarbon group having 6 to 50 carbon atoms, an unsubstituted or substituted aliphatic hydrocarbon group having 6 to 50 carbon atoms, or an unsubstituted nitrogen-containing heteroaromatic ring, and when the aromatic hydrocarbon group or the aliphatic hydrocarbon group has a substituent, the substituent is a group other than a hydroxy group.]

[2] The polymer according to [1], wherein the divalent organic group represented by $R^1$ in the above Formula (1) contains a group represented by the following Formula (2-1):

[Chem. 3]

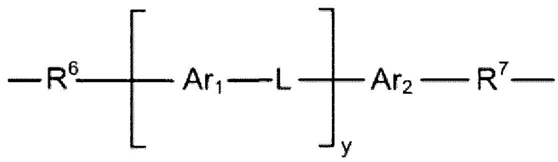

(2-1)

[wherein $Ar_1$ and $Ar_2$ are each independently an unsubstituted or substituted aromatic hydrocarbon group, L is a single bond, -O-, -S-, -$N(R^8)$-, -C(O)-, -C(O)-O-, -C(O)-NH-, -S(O)-, -$S(O)_2$-, -P(O)-, or a divalent organic group, $R^8$ is a hydrogen atom, a monovalent hydrocarbon group having 1 to 20 carbon atoms, or a monovalent halogenated hydrocarbon group having 1 to 20 carbon atoms, y is an integer of 0 to 5, when y is 2 or more, a plurality of $Ar_1$ and L may be the same as or different from each other, and $R^6$ and $R^7$ are each independently a single bond, a methylene group, or an alkylene group having 2 to 4 carbon atoms.]

[3] The polymer according to [2], wherein $Ar_1$ and $Ar_2$ in the Formula (2-1) are each independently an aromatic hydrocarbon group having an allyl group.

[4] The polymer according to any one of [1] to [3], wherein a weight average molecular weight of the polymer in terms of polystyrene is 1,000 to 500,000.

[5] A composition containing:

the polymer according to any one of [1] to [4]; and
a curable compound (B) other than the polymer.

[6] The composition according to [5], wherein the curable compound (B) contains at least one selected from the group consisting of a vinyl compound, a maleimide compound, an allyl compound, an acrylic compound, a methacrylic compound, a thiol compound, an oxazine compound, a cyanate compound, an epoxy compound, an oxetane compound, a methylol compound, a benzocyclobutene compound, a propargyl compound, and a silane compound.

[7] The composition according to [5] or [6], further containing an antioxidant.

[8] A cured product which is a cured product of the composition according to any one of [5] to [7].

[9] A laminate including:

a substrate; and
a cured layer formed using the composition according to any one of [5] to [7].

[10] An electronic component including the cured product according to [8] or the laminate according to [9].

Advantageous Effects of Invention

According to one embodiment of the present invention, it is possible to provide a polymer that has a low dielectric constant and a low loss tangent, and it is possible to provide a composition and a laminate that have a low dielectric constant and a low loss tangent and are excellent in curability, adhesiveness, and heat resistance in a well-balanced manner.

Description of Embodiments

Hereinafter, preferred embodiments according to the present invention will be described in detail. It should be understood that the present invention is not limited only to embodiments described below, but also includes various modifications performed without changing the gist of the present invention.

In the present specification, a numerical range described using "to" means including numerical values described before and after "to" as a lower limit value and an upper limit value.

Hereinafter, a polymer, a composition, a cured product, a laminate, or an electronic component according to one embodiment of the present invention will be described in detail.

<<Polymer>>

A polymer according to one embodiment of the present invention (hereinafter, also referred to as "polymer (A)") has a repeating structural unit represented by the following Formula (1), and a group Y (terminal group Y) represented by the following Formula (a) at a terminal.

[Chem. 4]

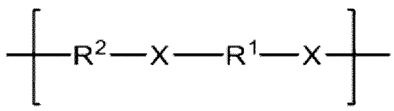

(1)

In Formula (1), X's are each independently -O-, -S-, or -N($R^3$)-. $R^3$ is a hydrogen atom, a monovalent hydrocarbon group having 1 to 20 carbon atoms, a monovalent halogenated hydrocarbon group having 1 to 20 carbon atoms, or a group obtained by substituting a part of the hydrocarbon group or the halogenated hydrocarbon group with at least one selected from an oxygen atom and a sulfur atom.

$R^1$ is a divalent organic group.

$R^2$ is a divalent unsubstituted or substituted nitrogen-containing heteroaromatic ring.

[Chem. 5]

-Y (a)

In Formula (a), Y is a group containing an ethylenically unsaturated double bond and having 3 to 50 carbon atoms, an unsubstituted or substituted aromatic hydrocarbon group having 6 to 50 carbon atoms, an unsubstituted or substituted aliphatic hydrocarbon group having 6 to 50 carbon atoms, or an unsubstituted nitrogen-containing heteroaromatic ring, and when the aromatic hydrocarbon group or the aliphatic hydrocarbon group has a substituent, the substituent is a group other than a hydroxy group.

The divalent organic group represented by $R^1$ preferably contains a group represented by the following Formula (2-1).

[Chem. 6]

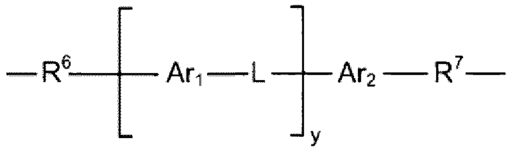

(2-1)

In Formula (2-1), $Ar_1$ and $Ar_2$ are each independently an unsubstituted or substituted aromatic hydrocarbon group.

L is a single bond, -O-, -S-, -N($R^8$)-, -C(O)-, -C(O)-O-, -C(O)-NH-, -S(O)-, -S(O)$_2$-, -P(O)-, or a divalent organic group, and $R^8$ is a hydrogen atom, a monovalent hydrocarbon group having 1 to 20 carbon atoms, or a monovalent halogenated hydrocarbon group having 1 to 20 carbon atoms.

y is an integer of 0 to 5. When y is 2 or more, a plurality of $Ar_1$ and L may be the same as or different from each other.

$R^6$ and $R^7$ are each independently a single bond, a methylene group, or an alkylene group having 2 to 4 carbon atoms.

The aromatic hydrocarbon groups represented by $Ar_1$ and $Ar_2$ are each independently preferably an aromatic hydrocarbon group having 6 to 30 carbon atoms, more preferably a phenyl group, a naphthyl group, or an anthryl group, and particularly preferably a phenyl group or a naphthyl group.

Each of the aromatic hydrocarbon groups represented by $Ar_1$ and $Ar_2$ may have 1 to 8 substituents. The number of substituents that each of the aromatic hydrocarbon groups represented by $Ar_1$ and $Ar_2$ has is preferably 0 to 8, more preferably 0 to 4, and still more preferably 0 to 2 from the viewpoint that, for example, the polymer (A) can be synthesized with good polymerization reactivity.

The substituent in $Ar_1$ and $Ar_2$ is not particularly limited, and examples thereof include an allyl group, a halogen atom, a monovalent hydrocarbon group having 1 to 20 carbon atoms, a monovalent halogenated hydrocarbon group having 1 to 20 carbon atoms, an alkoxy group having 1 to 20 carbon atoms, an alkylthio group having 1 to 20 carbon atoms, a nitro group, a cyano group, a carboxy group, a sulfonic acid group, a phosphonic acid group, a phosphoric acid group, a hydroxy group, primary to tertiary amino groups, a salt of a carboxy group, a salt of sulfonic acid group, a salt of phosphonic acid group, a salt of a phosphoric acid group, a salt of a hydroxy group, and a salt of primary to tertiary amino groups. Among these, an allyl group is preferable.

Examples of the halogen atom include a fluorine atom, a chlorine atom, a bromine atom, and an iodine atom.

Examples of the monovalent hydrocarbon group having 1 to 20 carbon atoms include a monovalent chain hydrocarbon group, a monovalent alicyclic hydrocarbon group, and a monovalent aromatic hydrocarbon group.

Examples of the chain hydrocarbon group include alkyl groups such as a methyl group, an ethyl group, a n-propyl group, an isopropyl group, a n-butyl group, an isobutyl group, a sec-butyl group, a tert-butyl group, and a n-pentyl group; alkenyl groups such as an ethenyl group, a propenyl group, a butenyl group, and a pentenyl group; and alkynyl groups such as an ethynyl group, a propynyl group, a butynyl group, and a pentynyl group.

Examples of the monovalent alicyclic hydrocarbon group include monocyclic cycloalkyl groups such as a cyclopropyl group, a cyclobutyl group, a cyclopentyl group, and a cyclohexyl group; polycyclic cycloalkyl groups such as a norbornyl group and an adamantyl group; monocyclic cycloalkenyl groups such as a cyclopropenyl group, a cyclobutenyl group, a cyclopentenyl group, and a cyclohexenyl group; and polycyclic cycloalkenyl groups such as a norbornenyl group.

Examples of the monovalent aromatic hydrocarbon group include aryl groups such as a phenyl group, a tolyl group, a xylyl group, a naphthyl group, and an anthryl group; and aralkyl groups such as a benzyl group, a phenethyl group, a phenylpropyl group, and a naphthylmethyl group.

Examples of the monovalent halogenated hydrocarbon group having 1 to 20 carbon atoms include groups in which some or all of hydrogen atoms of the monovalent hydrocarbon group having 1 to 20 carbon atoms are substituted with halogen atoms such as a fluorine atom, a chlorine atom, a bromine atom, and an iodine atom.

Examples of the alkoxy group having 1 to 20 carbon atoms include a methoxy group, an ethoxy group, a n-propoxy group, an isopropoxy group, a butoxy group, a pentyloxy group, a hexyloxy group, and an octyloxy group.

Examples of the alkylthio group having 1 to 20 carbon atoms include a methylthio group, an ethylthio group, a n-propylthio group, an isopropylthio group, a butylthio group, a pentylthio group, a hexylthio group, and an octylthio group.

The substituent (R) in the secondary amino group (-NHR) and the tertiary amino group (-NR$_2$) is not particularly limited, and examples thereof include a monovalent hydrocarbon group having 1 to 20 carbon atoms. Specific examples thereof include groups exemplified as substituents in the following nitrogen-containing heteroaromatic ring.

The cation constituting the cation site in the salt of a carboxy group, the salt of a sulfonic acid group, the salt of a phosphonic acid group, the salt of a phosphoric acid group, and the salt of a hydroxy group is not particularly limited, and examples thereof include known cations such as $Na^+$.

The anion constituting the anion site in the salt of the amino group is not particularly limited, and examples

thereof include known anions such as $Cl^-$.

From the viewpoint that, for example, a cured product having a high cross-linking density can be easily obtained, $Ar_1$ and $Ar_2$ may each independently be an aromatic hydrocarbon group having an allyl group.

The divalent organic group in L is preferably a divalent organic group having 1 to 20 carbon atoms, and examples thereof include a methylene group, an alkylene group having 2 to 20 carbon atoms, a halogenated methylene group, a halogenated alkylene group having 2 to 20 carbon atoms, a divalent cardo structure, and a group represented by the following Formula (L1).

[Chem. 7]

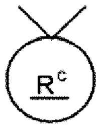

(L1)

In Formula (L1), $R^c$ is an unsubstituted or substituted 5- to 30-membered divalent alicyclic hydrocarbon group.

Examples of the alkylene group having 2 to 20 carbon atoms in L include an ethylene group, a n-propylene group, an isopropylene group, a n-butylene group, a sec-butylene group, a neopentylene group, a 4-methyl-pentane-2,2-diyl group, a nonane-1,9-diyl group, and a decane-1,1-diyl group.

Examples of the halogenated methylene group in L include groups in which some or all of hydrogen atoms of the methylene group are substituted with halogen atoms such as a fluorine atom, a chlorine atom, a bromine atom, and an iodine atom.

Examples of the halogenated alkylene group having 2 to 20 carbon atoms in L include groups in which some or all of hydrogen atoms of the alkylene group having 2 to 20 carbon atoms are substituted with halogen atoms such as a fluorine atom, a chlorine atom, a bromine atom, and an iodine atom.

Examples of the divalent cardo structure in L include a divalent group derived from fluorene represented by the following Formula (L2) (that is, a group excluding two hydrogen atoms in a compound having a fluorene skeleton).

[Chem. 8]

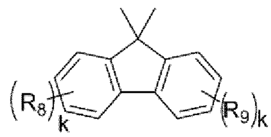

(L 2)

In Formula (L2), $R_8$ and $R_9$ are each independently a hydrogen atom, a fluorine atom, or a monovalent chain hydrocarbon group having 1 to 20 carbon atoms, and k is independently an integer of 0 to 4.

Examples of the divalent cardo structure include a structure derived from a compound represented by the following formula.

[Chem. 9]

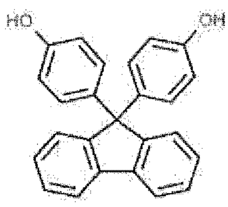

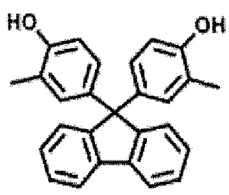

Examples of the unsubstituted or substituted 5- to 30-membered divalent alicyclic hydrocarbon group represented by $R^c$ include an unsubstituted or substituted 5- to 15-membered monocyclic alicyclic hydrocarbon group, an unsubstituted or substituted 5- to 15-membered monocyclic fluorinated alicyclic hydrocarbon group, an unsubstituted or substituted 7- to 30-membered polycyclic alicyclic hydrocarbon group, and an unsubstituted or substituted 7- to 30-membered polycyclic fluorinated alicyclic hydrocarbon group.

Examples of the unsubstituted or substituted 5- to 15-membered monocyclic alicyclic hydrocarbon group include a cyclopentane-1,1-diyl group, a cyclohexane-1,1-diyl group, a 3,3,5-trimethylcyclohexane-1,1-diyl group, a cyclopentene-3,3-diyl group, a cyclohexene-3,3-diyl group, a cyclooctane-1,1-diyl group, a cyclodecane-1,1-diyl group, a cyclododecane-1,1-diyl group, and a group in which some or all of hydrogen atoms of these groups are substituted with a monovalent chain hydrocarbon group having 1 to 20 carbon atoms.

Examples of the unsubstituted or substituted 5- to 15-membered monocyclic fluorinated alicyclic hydrocarbon group include a group in which some or all of hydrogen atoms of the group exemplified as the 5- to 15-membered monocyclic alicyclic hydrocarbon group are substituted with fluorine atoms.

Examples of the unsubstituted or substituted 7- to 30-membered polycyclic alicyclic hydrocarbon group include groups excluding two hydrogen atoms bonded to one carbon atom of a polycyclic alicyclic hydrocarbon such as norbornane, norbornene, adamantane, tricyclo[5.2.1.$0^{2,6}$]decane, tricyclo[5.2.1.$0^{2,6}$]heptane, pinane, camphane, decalin, nortricyclane, perhydroanthracene, perhydroazulene, cyclopentanohydrophenanthrene, and bicyclo[2.2.2]-2-octene, and a group in which some or all of hydrogen atoms of these groups are substituted with a monovalent chain hydrocarbon group having 1 to 20 carbon atoms.

Examples of the unsubstituted or substituted 7- to 30-membered polycyclic fluorinated alicyclic hydrocarbon group include a group in which some or all of hydrogen atoms of the group exemplified as the 7- to 30-membered polycyclic alicyclic hydrocarbon group are substituted with fluorine atoms.

$R^8$ in -N($R^8$)- is a hydrogen atom, a monovalent hydrocarbon group having 1 to 20 carbon atoms, or a monovalent halogenated hydrocarbon group having 1 to 20 carbon atoms, and examples of each of the monovalent hydrocarbon group having 1 to 20 carbon atoms and the monovalent halogenated hydrocarbon group having 1 to 20 carbon atoms include the monovalent hydrocarbon group having 1 to 20 carbon atoms and the monovalent halogenated hydrocarbon group having 1 to 20 carbon atoms exemplified for $Ar_1$.

From the viewpoint of the structure stability of the polymer (A), L is preferably a single bond, -O-, -S-, -C(O)-, -S(O)-, $-S(O)_2-$, -C(O)-NH-, -C(O)-O-, a methylene group, an alkylene group having 2 to 5 carbon atoms, a halogenated methylene group, a halogenated alkylene group having 2 to 10, or a divalent cardo structure.

From the same viewpoint, y is preferably 0 to 4 and more preferably 0 to 3.

Examples of the alkylene group having 2 to 4 carbon atoms in $R^6$ and $R^7$ include an ethylene group, a n-propylene group, an isopropylene group, a n-butylene group, and a sec-butylene group. From the viewpoint that the polymer (A) can be synthesized with good polymerization reactivity, $R^6$ and $R^7$ are preferably each independently a single bond, a methylene group, or an ethylene group.

Examples of the monomer as a raw material for the moiety containing $R^1$ include dihydroxyphenyl compounds such as hydroquinone, resorcinol, catechol, and phenylhydroquinone; bisphenol compounds such as 9,9-bis(4-hydroxyphenyl)fluorene, 9,9-bis(4-hydroxy-3-methylphenyl)fluorene, 9,9-bis(4-hydroxy-3-phenylphenyl)fluorene, 1,1-bis(4-hydroxyphenyl)-1-phenylethane, bis(4-hydroxyphenyl)diphenylmethane, 2,2-bis(4-hydroxyphenyl)propane, 2,2-bis(4-hydroxy-3-allylphenyl)propane, 2,2-bis(4-hydroxy-3-methylphenyl)propane, 2,2-bis(4-hydroxy-3-phenylphenyl)propane, 4,4'-(1,3-dimethylbutylidene)bisphenol, 1,1-bis(4-hydroxyphenyl)-nonane, bis(4-hydroxyphenyl)sulfone, 1,1-bis(4-hydroxyphenyl)cyclohexane, 1,1-bis(4-hydroxyphenyl)-3,3,5-trimethylcyclohexane, 1,1-bis(3-methyl-4-hydroxyphenyl)-3,3,5-trimethylcyclohexane, 1,1-bis(3-cyclohexyl-4-hydroxyphenyl)-3,3,5-trimethylcyclohexane, 1,4-bis[2-(4-hydroxyphenyl)-2-propyl]benzene, 1,3-bis[2-(4-hydroxyphenyl)-2-propyl]benzene, 4,4'-cyclododecylidene bisphenol, and 4,4'-decylidene bisphenol; and diol compounds such as Priplast 1901, 1838, 3186, 3192, 3197, and 3199 (manufactured by Croda Japan KK). One kind of these monomers may be used singly, or two or more kinds thereof may be used.

$R^2$ represents a divalent unsubstituted or substituted nitrogen-containing heteroaromatic ring.

Specific examples of the nitrogen-containing heteroaromatic ring include a pyrrole ring, a pyridine ring, a pyrimidine ring, a pyrazine ring, a pyridazine ring, a triazine ring, a quinoline ring, an isoquinoline ring, a quinoxaline ring, a phthalazine ring, a quinazoline ring, a naphthyridine ring, a carbazole ring, an acridine ring, and a phenazine ring.

The nitrogen-containing heteroaromatic ring is preferably a pyrimidine ring, for example, from the viewpoint that the polymer (A) can be synthesized with good polymerization reactivity, and the polymer (A) excellent in solubility in various organic solvents can be easily obtained.

The positions of two bonds bonded to the nitrogen-containing heteroaromatic ring (bonds bonded to X) are not particularly limited, but the meta position is preferable from the viewpoint that the polymer (A) can be synthesized with good polymerization reactivity.

Examples of the substituent in the nitrogen-containing heteroaromatic ring include a halogen atom, a monovalent hydrocarbon group having 1 to 20 carbon atoms, a monovalent halogenated hydrocarbon group having 1 to 20 carbon atoms, a group in which a part of the hydrocarbon group or the halogenated hydrocarbon group is substituted with at least one selected from an oxygen atom and a sulfur atom, a nitro group, a cyano group, an amino group, and a salt of an amino group.

Examples of the halogen atom include a fluorine atom, a chlorine atom, a bromine atom, and an iodine atom.

Examples of the monovalent hydrocarbon group having 1 to 20 carbon atoms include a monovalent chain

hydrocarbon group, a monovalent alicyclic hydrocarbon group, and a monovalent aromatic hydrocarbon group.

Examples of the chain hydrocarbon group include alkyl groups such as a methyl group, an ethyl group, a n-propyl group, an isopropyl group, a n-butyl group, an isobutyl group, a sec-butyl group, a tert-butyl group, and a n-pentyl group; alkenyl groups such as an ethenyl group, a propenyl group, a butenyl group, and a pentenyl group; and alkynyl groups such as an ethynyl group, a propynyl group, a butynyl group, and a pentynyl group.

Examples of the monovalent alicyclic hydrocarbon group include monocyclic cycloalkyl groups such as a cyclopropyl group, a cyclobutyl group, a cyclopentyl group, and a cyclohexyl group; polycyclic cycloalkyl groups such as a norbornyl group and an adamantyl group; monocyclic cycloalkenyl groups such as a cyclopropenyl group, a cyclobutenyl group, a cyclopentenyl group, and a cyclohexenyl group; and polycyclic cycloalkenyl groups such as a norbornenyl group.

Examples of the monovalent aromatic hydrocarbon group include aryl groups such as a phenyl group, a tolyl group, a xylyl group, a naphthyl group, and an anthryl group; and aralkyl groups such as a benzyl group, a phenethyl group, a phenylpropyl group, and a naphthylmethyl group.

Examples of the monovalent halogenated hydrocarbon group having 1 to 20 carbon atoms include groups in which some or all of hydrogen atoms of the monovalent hydrocarbon group having 1 to 20 carbon atoms are substituted with halogen atoms such as a fluorine atom, a chlorine atom, a bromine atom, and an iodine atom.

Specific examples of the group in which a part of the monovalent hydrocarbon group having 1 to 20 carbon atoms or the monovalent halogenated hydrocarbon group having 1 to 20 carbon atoms is substituted with at least one selected from an oxygen atom and a sulfur atom include a group in which a part of the hydrocarbon group or the halogenated hydrocarbon group is substituted with -O-, -S-, an ester group, or a sulfonyl group.

The amino group is not particularly limited, and may be a primary amino group ($-NH_2$), a secondary amino group (-NHR), or a tertiary amino group ($-NR_2$).

The substituent (R) in the secondary amino group and the tertiary amino group is not particularly limited, and examples thereof include the monovalent hydrocarbon group having 1 to 20 carbon atoms described above.

The anion constituting the anion site in the salt of the amino group is not particularly limited, and examples thereof include known anions such as $Cl^-$.

As the substituent in the nitrogen-containing heteroaromatic ring, from the viewpoint that the polymer (A) can be synthesized with good polymerization reactivity and the solubility of a monomer as a raw material for the polymer (A) is improved, a halogen atom, a monovalent hydrocarbon group having 1 to 6 carbon atoms, a monovalent halogenated hydrocarbon group having 1 to 6 carbon atoms, a nitro group, a cyano group, an amino group, or a salt of an amino group is preferable, and a fluorine atom, a chlorine atom, a methyl group, a nitro group, a cyano group, a tert-butyl group, a phenyl group, or a primary amino group is more preferable.

Examples of the monomer as a raw material for the moiety containing $R^2$ include pyrimidine compounds such as 4,6-dichloropyrimidine, 4,6-dibromopyrimidine, 2,4-dichloropyrimidine, 2,5-dichloropyrimidine, 2,5-dibromopyrimidine, 5-bromo-2-chloropyrimidine, 5-bromo-2-fluoropyrimidine, 5-bromo-2-iodopyrimidine, 2-chloro-5-fluoropyrimidine, 2-chloro-5-iodopyrimidine, 2-phenyl-4,6-dichloropyrimidine, 2-methylthio-4,6-dichloropyrimidine, 2-methylsulfonyl-4,6-dichloropyrimidine, 5-methyl-4,6-dichloropyrimidine, 2-amino-4,6-dichloropyrimidine, 5-amino-4,6-dichloropyrimidine, 2,5-diamino-4,6-dichloropyrimidine, 4-amino-2,6-dichloropyrimidine, 5-methoxy-4,6-dichloropyrimidine, 5-methoxy-2,4-dichloropyrimidine, 2-methyl-4,6-dichloropyrimidine, 6-methyl-2,4-dichloropyrimidine, 5-methyl-2,4-dichloropyrimidine, 5-nitro-2,4-dichloropyrimidine, 4-amino-2-chloro-5-fluoropyrimidine, 2-methyl-5-amino-4,6-dichloropyrimidine, and 5-bromo-4-chloro-2-methylthiopyrimidine; pyridazine compounds such as 3,6-dichloropyridazine, 3,5-dichloropyridazine, and 4-methyl-3,6-dichloropyridazine; and pyrazine compounds such as 2,3-dichloropyrazine, 2,6-dichloropyrazine, 2,5-dibromopyrazine, 2,6-dibromopyrazine, 2-amino-3,5-dibromopyrazine, and 5,6-dicyano-2,3-dichloropyrazine. One kind of these monomers may be used singly, or two or more kinds thereof may be used.

X's in Formula (1) are each independently -O-, -S-, or $-N(R^3)-$. X is preferably -O- from the viewpoint of flexibility, solubility, and heat resistance. X is preferably $-N(R^3)-$ from the viewpoint of, for example, adhesion.

$R^3$ is a hydrogen atom, a monovalent hydrocarbon group having 1 to 20 carbon atoms, a monovalent halogenated hydrocarbon group having 1 to 20 carbon atoms, or a group obtained by substituting a part of the hydrocarbon group or the halogenated hydrocarbon group with at least one selected from an oxygen atom and a sulfur atom.

Examples of each of the monovalent hydrocarbon group having 1 to 20 carbon atoms and the monovalent halogenated hydrocarbon group having 1 to 20 carbon atoms in $R^3$ include the monovalent hydrocarbon group having 1 to 20 carbon atoms and the monovalent halogenated hydrocarbon group having 1 to 20 carbon atoms exemplified for $Ar_1$. Specific examples of the group in which a part of the monovalent hydrocarbon group having 1 to 20 carbon atoms or the monovalent halogenated hydrocarbon group having 1 to 20 carbon atoms is substituted with at least one selected from an oxygen atom and a sulfur atom in $R^3$ include a group in which a part or all of the hydrocarbon group or the halogenated hydrocarbon group is substituted with an ester group or a sulfonyl group.

From the viewpoint that the polymer (A) can be synthesized with good polymerization reactivity, $R^3$ is preferably a hydrogen atom or a monovalent hydrocarbon group having 1 to 10 carbon atoms.

In Formula (1), when both X's on both sides of $R^1$ are - $N(R^3)$-, two $R^3$'s may be the same as or different from

each other.

The polymer (A) may usually have another structural unit in addition to the repeating unit represented by the above Formula (1), as necessary. Therefore, the repeating units represented by the above Formula (1) are bonded to each other, or bonded to the other structural units or the terminal group Y represented by Formula (a).

When the polymer (A) has a plurality of repeating units represented by Formula (1), a plurality of $R^1$'s may be the same as or different from each other. The same applies to $R^2$ and other repeating units.

Examples of the monomer from which the other structural unit is derived include compounds from which a structural unit containing a carbonate bond, a thiocarbonate bond, or a selenocarbonate bond is derived, such as diphenyl carbonate, diphenyl thiocarbonate, diphenyl selenocarbonate, phosgene, thiophosgene, or selenophosgene; dihydroxy compounds such as benzenedimethanol and cyclohexanedimethanol; phosphine oxide compounds such as bis(fluorophenyl)phenylphosphine oxide, bis(fluorophenyl)naphthylphosphine oxide, and bis(fluorophenyl)anthrylphosphine oxide; and dihalides of dicarboxylic acids such as phthalic acid dichloride, isophthalic acid dichloride, and terephthalic acid dichloride. One kind of these monomers may be used singly, or two or more kinds thereof may be used.

The terminal group Y (terminal structure) of the polymer (A) is represented by the following Formula (a).

[Chem. 10]

$$-Y \qquad (a)$$

In Formula (a), Y is a group containing an ethylenically unsaturated double bond and having 3 to 50 carbon atoms, an unsubstituted or substituted aromatic hydrocarbon group having 6 to 50 carbon atoms, an unsubstituted or substituted aliphatic hydrocarbon group having 6 to 50 carbon atoms, or an unsubstituted nitrogen-containing heteroaromatic ring, and when the aromatic hydrocarbon group or the aliphatic hydrocarbon group has a substituent, the substituent is a group other than a hydroxy group.

The terminal group Y is bonded to the main chain terminal of the polymer (A), and specifically, forms a terminal moiety of the polymer (A) represented by the following Formula (a1) or (a2). That is, the terminal group Y is a group different from the group constituting the end portion (for example: substituents in $Ar_1$, $Ar_2$, and $R^2$, $R^3$ in -N($R^3$)- of X) in $R^1$, $R^2$, and X.

[Chem. 11]

$$—X'—R^1—X—Y \qquad (a1)$$

$$—X'—R^2—X—Y \qquad (a2)$$

In Formulae (a1) and (a2),

Y has the same meaning as Y in the above Formula (a).
X, $R^1$, and $R^2$ have the same meaning as X, $R^1$, and $R^2$ in the above Formula (1).
X' is a single bond, -O-, -S-, or -N($R^3$)-. $R^3$ has the same meaning as $R^3$ in the above Formula (1).

The terminal group Y is preferably an aromatic or aliphatic hydrocarbon group having small polarization or a nitrogen-containing heteroaromatic ring in order to improve dielectric properties, and when the terminal group Y further contains an ethylenically unsaturated double bond, the cross-linking density can be improved, and thus heat resistance and curability can be expected.

Examples of the group containing an ethylenically unsaturated double bond and having 3 to 50 carbon atoms include aromatic ring-containing groups such as a 3-isopropenylphenyl group, a 4-isopropenylphenyl group, a 2-allylphenyl group, a 2-methoxy-4-allylphenyl group, a 4-(1-propenyl)-2-methoxyphenyl group, a 4-vinylbenzyl group, a 3-vinylbenzyl group, and a 2-vinylbenzyl group, an allyl group, an acrylic group, a methacrylic group, and a methallyl group.

Examples of the aromatic hydrocarbon group having 6 to 50 carbon atoms include aryl groups such as a phenyl group, a biphenyl group, a tolyl group, a xylyl group, a naphthyl group, and an anthryl group; and aralkyl groups such as a benzyl group, a phenethyl group, a phenylpropyl group, and a naphthylmethyl group.

Examples of the aliphatic hydrocarbon group having 6 to 50 carbon atoms include monocyclic cycloalkyl groups such as a cyclopropyl group, a cyclobutyl group, a cyclopentyl group, and a cyclohexyl group; polycyclic cycloalkyl groups such as a norbornyl group and an adamantyl group; monocyclic cycloalkenyl groups such as a cyclopropenyl group, a cyclobutenyl group, a cyclopentenyl group, and a cyclohexenyl group; and polycyclic cycloalkenyl groups such as a norbornenyl group.

Examples of the unsubstituted nitrogen-containing heteroaromatic ring include the same rings as the rings exemplified for $R^2$.

The substituent in the unsubstituted or substituted aromatic hydrocarbon group having 6 to 50 carbon atoms, the unsubstituted or substituted aliphatic hydrocarbon group having 6 to 50, and the unsubstituted nitrogen-containing heteroaromatic ring is a group other than a hydroxy group, and specific examples thereof include groups similar to the groups exemplified as the substituent in $Ar_1$.

The substituent is not particularly limited, and examples thereof include an allyl group, a halogen atom, a monovalent hydrocarbon group having 1 to 20 carbon atoms, a monovalent halogenated hydrocarbon group having 1 to 20 carbon atoms, an alkoxy group having 1 to 20 carbon atoms, an alkylthio group having 1 to 20 carbon atoms, a nitro group, a cyano group, a carboxy group, a sulfonic acid group, a phosphonic acid group, a phosphoric acid group, primary to tertiary amino groups, a salt of a carboxy group, a salt of sulfonic acid group, a salt of phosphonic acid group, a salt of a phosphoric acid group, and a salt of primary to tertiary amino groups. Among these, an allyl group is preferable.

In addition to the monomers to give $R^1$ and $R^2$ in the above Formula (1), at least one monomer for forming the terminal group Y selected from the group consisting of a monovalent phenol, a monovalent amine, a monovalent thiol, a monovalent aromatic halide, a monovalent aliphatic halide, a monovalent acid halide, and a monovalent acid anhydride is used as a raw material and reacted, whereby a polymer (A) having a terminal sealed with the terminal group Y can be obtained.

In the case of synthesizing the polymer (A) in which the terminal group Y contains a double bond, for example, in order to avoid that the double bonds in the monomer for forming the terminal group Y react with each other and gel at the time of polymerization of the monomer as a raw material for the moiety containing $R^1$ and the monomer as a raw material for the moiety containing $R^2$, the monomer for forming the terminal group Y may be added and reacted after polymerization of the monomer as a raw material for the moiety containing $R^1$ and the monomer as a raw material for the moiety containing $R^2$.

Examples of the monomer for forming the terminal group Y include monovalent phenol compounds such as t-butylphenol, nonylphenol, 4-isopropenylphenol, 4-vinylphenol, 2-allylphenol, isoeugenol, tocotrienol, α-tocophenol, 4-hydroxyphenylmaleimide, and 2-phenylphenol; monovalent amines compound such as 4-hexylaniline and diallylamine; monovalent thiol compounds such as 1-octanethiol; monovalent aliphatic halides such as allyl chloride, 4-(chloromethyl)styrene, and 3-(chloromethyl)styrene; monovalent acid halides such as acrylic chloride, methacrylic chloride, crotonoyl chloride, and cinnamoyl chloride; and monovalent acid anhydrides such as acrylic anhydride, crotonic anhydride, and methacrylic anhydride. One kind of these monomers may be used singly, or two or more kinds thereof may be used.

The content ratio of the repeating unit represented by the above Formula (1) in the polymer (A) is preferably 30 mol% or more, more preferably 50 mol% or more, and still more preferably 60 mol% or more, and is preferably 99.5 mol% or less, more preferably 98 mol% or less, and still more preferably 95 mol% or less.

<Sequence of Each Repeating Unit>

Examples of the polymer (A) having the repeating unit represented by the above Formula (1) and the terminal group Y represented by the above Formula (a) include polymers having, for example, a combination of these repeating units in the main chain, and specific examples thereof include a polymer represented by the following Formula (3) or (4). The "main chain" refers to a relatively longest bonded chain in the polymer.

[Chem. 12]

$$Y-X-R^1-X'\left[-R^2-X-R^1-X-\right]_n R^2-X'-R^1-X-Y \quad (3)$$

$$Y-X-R^2-X'-R^1-X'\left[-R^2-X-R^1-X-\right]_n X'-R^2-X-Y \quad (4)$$

In the above formula, $R^1$, $R^2$, X, Y, and X' have the same meaning as $R^1$, $R^2$, X, Y, and X' in the above Formulae (1), (a), (a1), and (a2). n is an integer of 0 to 100 and more preferably 2 to 30.

In the above formula, a plurality of $R^1$, $R^2$, X, Y, and X' may be the same as or different from each other.

<Method for Synthesizing Polymer (A)>

A method for synthesizing the polymer (A) is not particularly limited, and a known method can be used. For example, the polymer (A) can be synthesized by heating the monomer as a raw material for the moiety containing $R^1$, the monomer as a raw material for the moiety containing $R^2$, the monomer for forming the terminal group Y, and as necessary, the monomer from which the other structural unit is derived in an organic solvent together with, for example, an alkali metal or an alkali metal compound. After polymerizing the monomer as a raw material for the moiety containing $R^1$ and the monomer as a raw material for the moiety containing $R^2$, then the monomer from which the other structural unit is derived and the monomer for forming the terminal group Y may be heated, and may be mixed and reacted with the obtained polymer.

· Alkali Metal and Alkali Metal Compound

When a compound having a hydroxy group such as a phenol compound is used as a raw material in the process of synthesizing the polymer (A), the alkali metal and the alkali metal compound react with the compound having a hydroxy group to form an alkali metal salt.

Examples of such an alkali metal and alkali metal compound include

alkali metals such as lithium, sodium, and potassium;
alkali metal hydrides such as lithium hydride, sodium hydride, and potassium hydride;
alkali metal hydroxides such as lithium hydroxide, sodium hydroxide, and potassium hydroxide;
alkali metal carbonates such as lithium carbonate, sodium carbonate, and potassium carbonate; and
alkali metal hydrogen carbonates such as lithium hydrogen carbonate, sodium hydrogen carbonate, and potassium hydrogen carbonate.

Among these, an alkali metal carbonate is preferable, and potassium carbonate is more preferable.

When a compound having a hydroxy group is used at the time of synthesis of the polymer (A), as amounts of the alkali metal and the alkali metal compound used, the lower limit of a ratio of the number of moles of alkali metal atoms to the number of moles of hydroxy groups in all compounds used in the synthesis of the polymer (A) is preferably 1, more preferably 1.1, and still more preferably 1.2, and the upper limit of the ratio is preferably 3, more preferably 2, and still more preferably 1.8.

· Organic Solvent

Examples of the organic solvent include

ether-based solvents such as tetrahydrofuran (THF), dioxane, cyclopentyl methyl ether, anisole, phenetol, diphenyl ether, dialkoxybenzene, and trialkoxybenzene;
nitrogen-containing solvents such as N,N-dimethylacetamide (DMAc), N,N-dimethylformamide, N-methyl-2-pyrrolidone, and 1,3-dimethyl-2-imidazolidinone;
ester-based solvents such as γ-butyrolactone;
sulfur-containing solvents such as sulfolane, dimethyl sulfoxide, diethyl sulfoxide, dimethyl sulfone, diethyl sulfone, diisopropyl sulfone, and diphenyl sulfone;
ketone-based solvents such as benzophenone, 2-heptanone, cyclohexanone, and methyl ethyl ketone;
halogen-based solvents such as methylene chloride, chloroform, and chlorobenzene; and
aromatic hydrocarbon-based solvents such as benzene, toluene, and xylene.

Among these organic solvents, 2-heptanone, cyclohexanone, N-methyl-2-pyrrolidone, toluene, and xylene are preferable, and N-methyl-2-pyrrolidone, 2-heptanone, and cyclohexanone are more preferable.

The lower limit of the reaction temperature at the time of the synthesis is preferably 50°C and more preferably 80°C, and the upper limit thereof is preferably 300°C and more preferably 200°C.

The lower limit of the reaction time at the time of the synthesis is preferably 1 hour, more preferably 2 hours, and still more preferably 3 hours, and the upper limit thereof is preferably 100 hours, more preferably 50 hours, and still more preferably 24 hours.

For the purpose of suppressing gelation of a polymerization liquid, the lower limit of the reaction temperature when the monomer for forming the terminal group Y is added after polymerization is preferably 0°C and more preferably 10°C, and the upper limit thereof is preferably 130°C and more preferably 110°C.

The lower limit of the reaction time when the monomer for forming the terminal group Y is added and reacted

after polymerization is preferably 1 hour, more preferably 2 hours, and still more preferably 3 hours, and the upper limit thereof is preferably 48 hours, more preferably 24 hours, and still more preferably 10 hours.

[Physical Properties of Polymer (A)]

The lower limit of the weight average molecular weight (Mw) of the polymer (A) in terms of polystyrene is preferably 1,000, more preferably 2,000, still more preferably 3,000, and particularly preferably 5,000, and the upper limit thereof is preferably 500,000, more preferably 100,000, still more preferably 50,000, more preferably 30,000, and particularly preferably 15,000.
The polymer (A) having an Mw in the above range is excellent in balance, for example, among adhesion, heat resistance, impregnation into a glass cloth, moldability such as resin flow, which is preferable.
The Mw in the present invention is a value as measured by gel permeation chromatography (GPC) under the conditions described in the following Examples.
The loss tangent (tanδ) of the polymer (A) is preferably less than 0.0030, more preferably 0.0020 or less, and still more preferably 0.0012 or less, and the lower limit thereof is not particularly limited, and is preferably 0.0005 or more, from the viewpoint that, for example, the transmission loss when a composition containing the polymer (A) is obtained can be reduced.
Specifically, the loss tangent can be measured by the method described in the following Examples.

<<Composition>>

A composition according to one embodiment of the present invention (hereinafter, also referred to as "present composition") is not particularly limited as long as it contains the polymer (A), but preferably contains a curable compound (B) other than the polymer (A). The present composition may further contain other components such as a curing aid.

<Polymer (A)>

The polymer (A) used in the present composition may be one or two or more kinds. The present composition may be a mixture of two or more kinds of the polymers (A).
In the case of using two or more kinds of the polymers (A), for example, the polymer (A) having a different molecular weight in the above range of the molecular weight of the polymer (A) can be mixed depending on, for example, desired physical properties.
For example the content ratio of the polymer (A) in the present composition is preferably 0.05 mass% or more, more preferably 10 mass% or more, and still more preferably 20 mass% or more, and preferably 99.95 mass% or less, more preferably 90 mass% or less, and still more preferably 80 mass% or less, when the total solid content in the present composition is regarded as 100 mass%.
When the content ratio of the polymer (A) is in the above range, it is preferable from the viewpoint that, for example, adhesiveness, heat resistance, curability, and electrical properties of a cured product obtained from the present composition can be further improved.

<Curable Compound (B)>

The curable compound (B) (hereinafter, also referred to as "compound (B)") is a compound other than the polymer (A), is a compound that cures by heat or irradiation with light (for example: visible light, ultraviolet light, near infrared light, or far infrared light), and may require a curing aid described below. Examples of such a compound (B) include a vinyl compound, a maleimide compound, an allyl compound, an acrylic compound, a methacrylic compound, a thiol compound, an oxazine compound, a cyanate compound, an epoxy compound, an oxetane compound, a methylol compound, a benzocyclobutene compound, a propargyl compound, and a silane compound. Among these, from the viewpoint of, for example, compatibility and reactivity with the polymer (A), particularly, at least one of a vinyl compound, a maleimide compound, and an allyl compound is preferable.
One kind of the compound (B) may be used singly, or two or more kinds thereof may be used.
Examples of the vinyl compound include compounds represented by the following Formulae (b-1-1) to (b-1-5).
Examples of the vinyl compound further include, as a styrene-based thermoplastic elastomer such as a styrene butadiene styrene copolymer (SBS), a hydrogenated styrene butadiene styrene copolymer (SEBS), a styrene isoprene styrene copolymer (SIS), a hydrogenated styrene isoprene styrene copolymer, a styrene butadiene elastomer (SBR), and compounds containing a vinyl group such as tert-butylstyrene, and 2-vinyl-4,6-diamino-1,3,5-triazine.
Examples of the vinyl compound further include TA100 (manufactured by MITSUBISHI GAS CHEMICAL COMPANY, INC.) and ULL-950S (manufactured by LONZA).

[Chem. 13]

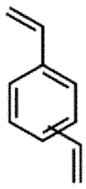

b-1-1

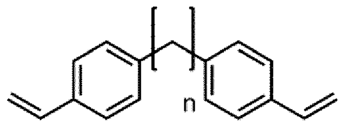

b-1-2

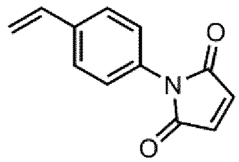

b-1-3

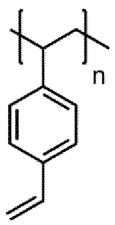

b-1-4

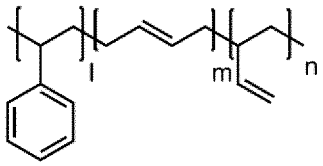

b-1-5

In Formulae (b-1-2) and (b-1-4), n is independently 1 to 5000. In Formula (b-1-5), l, m, and n are each independently 1 to 5000.

Examples of the maleimide compound include compounds represented by the following Formulae (b-2-1) to (b-2-8).

[Chem. 14]

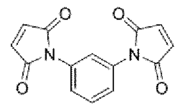

b-2-1

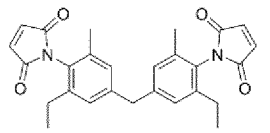

b-2-2

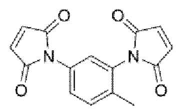

b-2-3

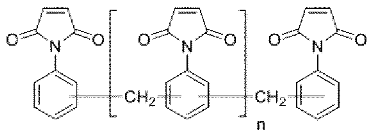

b-2-4

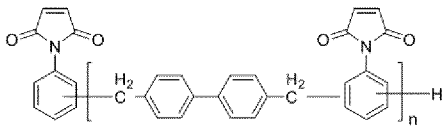

b-2-5

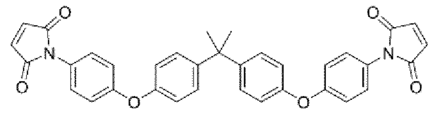

b-2-6

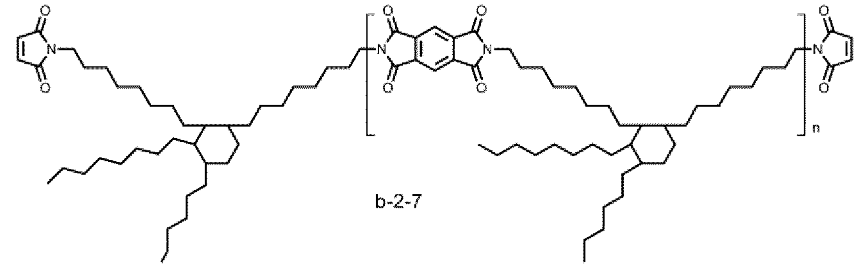

b-2-7

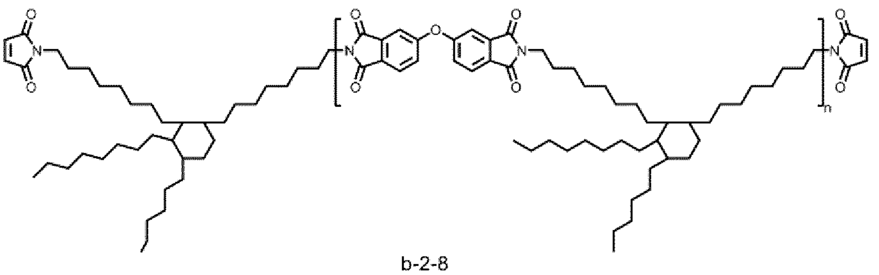

b-2-8

In Formulae (b-2-4), (b-2-5), (b-2-7), and (b-2-8), n is independently 1 to 50.

Examples of the allyl compound include compounds represented by the following Formulae (b-3-1) to (b-3-6).

[Chem. 15]

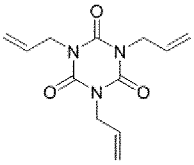 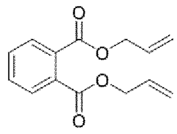 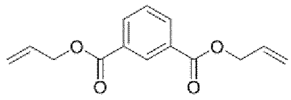

b-3-1 b-3-2 b-3-3

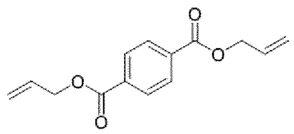 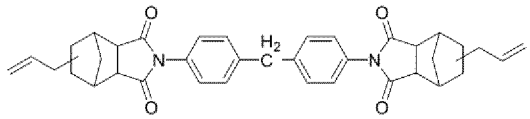

b-3-4 b-3-5

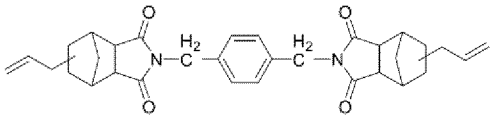

b-3-6

Examples of the acrylic compound include compounds represented by the following Formulae (b-4-1) to (b-4-7).

[Chem. 16]

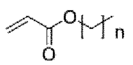 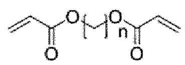 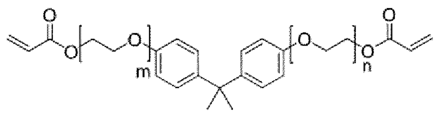

b-4-1 b-4-2 b-4-3

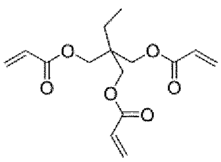 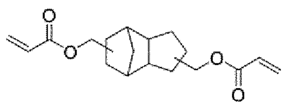

b-4-5

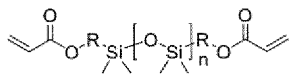

b-4-4

b-4-6

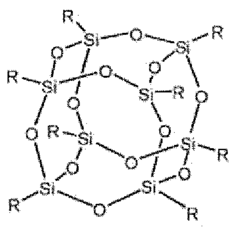 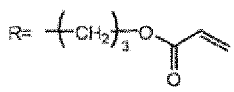

b-4-7

In Formulae (b-4-1), (b-4-2), (b-4-3), and (b-4-6), n is independently 1 to 50. In Formula (b-4-3), m is 1 to 50. In Formula (b-4-6), R is a divalent hydrocarbon group having 1 to 20 carbon atoms.

Examples of the methacrylic compound include bisphenol A-type epoxy methacrylate, phenol novolac-type epoxy methacrylate, trimethylolpropane methacrylate, dipentaerythritol hexamethacrylate, and SA-9000 (manufactured by SABIC).

Examples of the thiol compound include 1,4-bis(3-mercaptobutyryloxy)butane, 1,3,5-tris(2-(3-sulfanylbutanoyloxy)ethyl)-1,3,5-triazinane-2,4,6-trione, 2-(dibutylamino)-1,3,5-triazine-4,6-dithiol, and 6-diallylamino-1,3,5-triazine-2,4-dithiol.

Examples of the silane compound include KF-99 (manufactured by Shin-Etsu Chemical Co., Ltd.) and KF-9901 (manufactured by Shin-Etsu Chemical Co., Ltd.).

Examples of the oxazine compound include compounds represented by the following Formulae (b-5-1) to (b-5-5).

[Chem. 17]

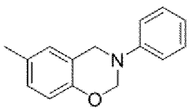

b-5-1

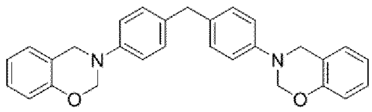

b-5-2

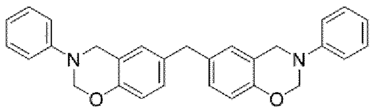

b-5-3

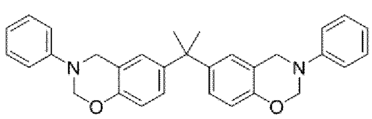

b-5-4

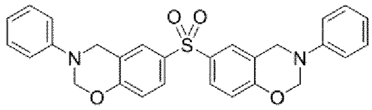

b-5-5

Examples of the cyanate compound include compounds represented by the following Formulae (b-6-1) to (b-6-7).

[Chem. 18]

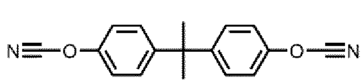

b-6-1

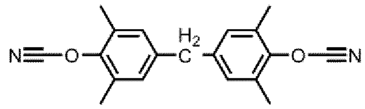

b-6-2

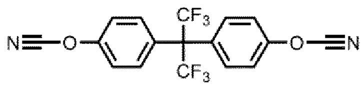

b-6-3

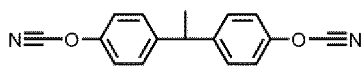

b-6-4

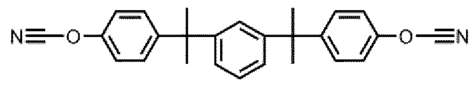

b-6-5

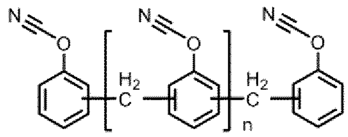

b-6-6

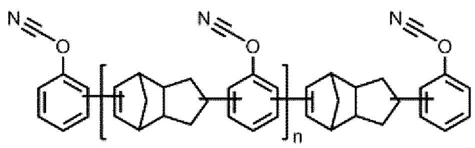

b-6-7

In Formulae (b-6-6) and (b-6-7), n is independently 0 to 30.

Examples of the epoxy compound include compounds represented by the following Formulae (b-7-1) to (b-7-5).

Examples of the epoxy compound further include polyglycidyl ether of a dicyclopentadiene-phenol polymer, a phenol novolac-type liquid epoxy compound, a cresol novolac-type epoxy compound, an epoxidized product of a styrenebutadiene block copolymer, 3',4'-epoxycyclohexylmethyl-3,4-epoxycyclohexanecarboxylate, XER-81 (manufactured by JSR Corporation, epoxy group-containing NBR particles), and JP-100 (manufactured by Nippon Soda Co., Ltd.).

[Chem. 19]

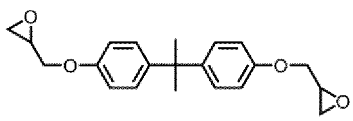

b-7-1

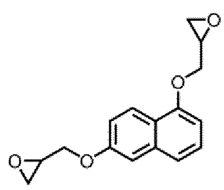

b-7-2

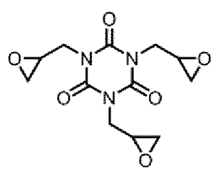

b-7-3

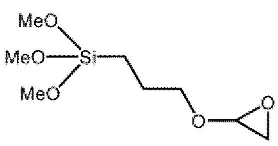

b-7-4

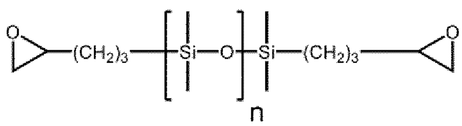

b-7-5

In Formula (b-7-5), n is 0 to 5000.

Examples of the oxetane compound include compounds represented by the following Formulae (b-8-1) to (b-8-3).

[Chem. 20]

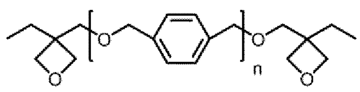

b-8-1

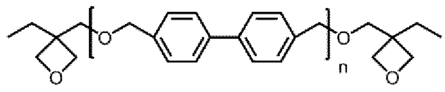

b-8-2

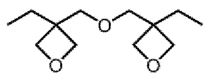

b-8-3

In Formulae (b-8-1) and (b-8-2), n is each independently 0 to 30.

Examples of the methylol compound include methylol compounds described in JP 2006-178059 A and JP 2012-226297 A. Specific examples thereof include melamine-based methylol compounds such as polymethylolated melamine, hexamethoxymethylmelamine, hexaethoxymethylmelamine, hexapropoxymethylmelamine, and hexabutoxymethylmelamine; glycoluril-based methylol compounds such as polymethylolated glycoluril, tetramethoxymethylglycoluril, and tetrabutoxymethylglycoluril; guanamine-based methylol compounds such as compounds in which guanamine is methylolated, such as 3,9-bis[2-(3,5-diamino-2,4,6-triazaphenyl)ethyl]-2,4,8,10-tetraoxospiro[5.5]undecane and 3,9-bis[2-(3,5-diamino-2,4,6-triazaphenyl)propyl]-2,4,8,10-tetraoxospiro[5.5]undecane, and compounds in which all or a part of active methylol groups in these compounds are alkyletherified.

Examples of the benzocyclobutene compound include compounds described in JP 2005-60507 A.

Examples of the propargyl compound include compounds represented by the following Formulae (b-9-1) to (b-9-2).

[Chem. 21]

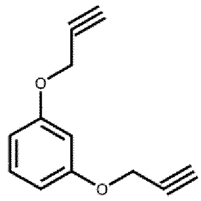

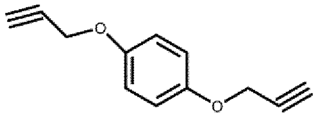

b-9-1

b-9-2

[Content Ratio of Compound (B)]

For example the content ratio of the compound (B) in the present composition is preferably 0.05 mass% or more, more preferably 10 mass% or more, and still more preferably 20 mass% or more, and is preferably 99.95 mass% or less, more preferably 90 mass% or less, and still more preferably 80 mass% or less, when the total solid content in the present composition is regarded as 100 mass%.

When the content ratio of the compound (B) is in the above range, it is preferable from the viewpoint that, for example, strength, heat resistance, and chemical resistance of a cured product obtained from the present composition can be further improved.

When the total solid content of the polymer (A) and the compound (B) in the present composition is regarded as 100 mass%, the content ratio of the compound (B) is preferably 1 mass% or more, more preferably 5 mass% or more, and still more preferably 10 mass% or more, and is preferably 99 mass% or less, more preferably 95 mass% or less, and still more preferably 90 mass% or less.

When the content ratio of the compound (B) is in the above range, it is preferable from the viewpoint that, for example, toughness, heat resistance, and chemical resistance of a cured product obtained from the present composition can be further improved.

<Other components>

The present composition may contain other components as long as the effect of the present invention is not impaired, in addition to the polymer (A) and the compound (B) .
Examples of the other components include a curing aid, a solvent, a polymerization inhibitor for increasing stability, an antioxidant, an inorganic filler, an organic filler, an adhesion aid, a lubricant, a flame retardant, an antibacterial agent, a colorant, a release agent, a foaming agent, and a polymer other than the polymer (A).
One kind of each of these other components may be used singly, or two or more kinds thereof may be used.

[Curing Aid]

The present composition may contain a curing aid as necessary.
Examples of the curing aid include polymerization initiators such as a thermal radical or photoradical initiator, a cationic curing agent, and an anionic curing agent.
Examples of the thermal radical initiator include organic peroxides such as dicumyl peroxide, 1,1-di(t-butylperoxy)cyclohexane, di(t-butylperoxyisopropyl)benzene, 2,5-dimethyl-2,5-di(t-butylperoxy)hexine-3, and benzoyl peroxide; and azo compounds such as azobisbutyronitrile, 1,1'-azobis(1-acetoxy-1-phenylethane)], 2,2'-azobis(2,4-dimethylvaleronitrile), 1,1'-azobis(cyclohexane-1-carbonitrile), dimethyl-2,2'-azobis(isobutyrate), and 2,2'-azobis(2-methylbutyronitrile) .
Examples of the cationic curing agent include diallylyodonium salts having $BF_4$, $PF_6$, or $SbF_6$ as a counter anion, such as SP70, SP172, and CP66 manufactured by ADEKA CORPORATION, CI2855 and CI2823 manufactured by Nippon Soda Co., Ltd., and SI100 and SI150 manufactured by SANSHIN CHEMICAL INDUSTRY CO., LTD.; trialkylsulfonium salts; phosphonium salts such as butyltriphenylphosphonium thiocyanate; and boron trifluoride.
Examples of the anionic curing agent include imidazole compounds such as 2-methylimidazole, 2-ethyl-4-methylimidazole, 2-undecylimidazole, 2-heptadecylimidazole, 2-phenylimidazole, 1-benzyl-2-methylimidazole, 1-cyanoethyl-2-methylimidazole, 1-cyanoethyl-2-ethyl-4-methylimidazole, 2-methylimidazolium isocyanurate, 2,4-diamino-6-[2-methylimidazolin-(1)]-ethyl-S-triazine, and 2,4-diamino-6-[2-ethyl-4-methylimidazolin-(1)]-ethyl-S-triazine; phosphorus compounds such as triphenylphosphine; and amine compounds such as 4,4'-diaminodiphenylmethane.
Examples of the curing aid when a silane compound is used as the compound (B) include zinc benzoate, zinc octylate and platinum group metal catalysts such as platinum-based catalysts such as platinum black, platinic chloride, chloroplatinic acid, a reaction product of chloroplatinic acid with monohydric alcohol, chloroplatinic acid-olefin complexes, and platinum bisacetoacetate; palladium-based catalysts; and rhodium-based catalyst.
Examples of the curing aid when an oxazine compound is used as the compound (B) include phenol and derivatives thereof, cyanic acid ester, Bronsted acids such as p-toluenesulfonic acid, adipic acid, p-toluenesulfonic acid ester, aromatic amine compounds such as 4,4'-diaminodiphenylsulfone, and melamine, bases such as 2-ethyl-4-methylimidazole, and curing agents such as boron trifluoride and Lewis acid.
When the present composition contains a curing aid, the content ratio of the curing aid is preferably in a range in which the present composition is satisfactorily cured to obtain a cured product. Specifically, the content ratio of the curing aid is preferably 0.000001 parts by mass or more and more preferably 0.001 parts by mass or more, and is preferably 20 parts by mass or less and more preferably 10 parts by mass or less, with respect to 100 parts by mass of the total solid content of the polymer (A) and the compound (B).

[Solvent]

The present composition may contain a solvent as necessary.
Examples of the solvent include amide-based solvents such as N,N-dimethylformamide; ester-based solvents such as $\gamma$-butyrolactone and butyl acetate; ketone-based solvents such as cyclopentanone, cyclohexanone, methyl ethyl ketone, and 2-heptanone; ether-based solvents such as 1,2-methoxyethane, anisole, and tetrahydrofuran, polyfunctional solvents such as 1-methoxy-2-propanol and propylene glycol methyl ether acetate; sulfone-based solvents such as dimethyl sulfoxide; methylene chloride, benzene, toluene, xylene, and trialkoxybenzene (number of carbon atoms of an alkoxy group; 1 to 4).
When the present composition contains a solvent, for example, the content ratio of the solvent in the present composition is not particularly limited, but is preferably 0 parts by mass or more and 2000 parts by mass or less, and more preferably 0 parts by mass or more and 1000 parts by mass or less with respect to 100 parts by mass of the total solid content of the polymer (A) and the compound (B).
When the solubility of the polymer (A) or the compound (B) in the solvent is high, the content ratio of the solvent in the present composition may be 50 parts by mass or more and 200 parts by mass or less.

[Polymerization Inhibitor]

Examples of the polymerization inhibitor include quinones such as hydroquinone, methylhydroquinone, p-benzoquinone, chloranil, and trimethylquinone, and aromatic diols.

When the present composition contains a polymerization inhibitor, for example, the content ratio of the polymerization inhibitor is preferably 0.000001 parts by mass or more and 10 parts by mass or less with respect to 100 parts by mass of the total solid content of the polymer (A) and the compound (B).

[Antioxidant]

Examples of the antioxidant include a hindered phenol-based compound, a phosphorus-based compound, a sulfur-based compound, a metal-based compound, and a hindered amine-based compound. Among these, a hindered phenol-based compound is preferable.

The hindered phenol-based compound is preferably a compound having a molecular weight of 500 or more. Examples of the hindered phenol-based compound having a molecular weight of 500 or more include triethylene glycol-bis[3-(3-t-butyl-5-methyl-4-hydroxyphenyl)propionate], 1,6-hexanediol-bis[3-(3,5-di-t-butyl-4-hydroxyphenyl)propionate], 2,4-bis-(n-octylthio)-6-(4-hydroxy-3,5-di-t-butylanilino)-3,5-triazine, pentaerythritol tetrakis[3-(3,5-t-butyl-4-hydroxyphenyl)propionate], 1,1,3-tris[2-methyl-4-[3-(3,5-dit-butyl-4-hydroxyphenyl)propionyloxy]-5-t-butylphenyl]butane, 2,2-thio-diethylene bis[3-(3,5-di-t-butyl-4-hydroxyphenyl)propionate], octadecyl-3-(3,5-di-t-butyl-4-hydroxyphenyl)propionate, N,N-hexamethylene bis(3,5-di-t-butyl-4-hydroxy-hydrocinnamamide), 1,3,5-trimethyl-2,4,6-tris(3,5-di-t-butyl-4-hydroxybenzyl)benzene, tris-(3,5-di-t-butyl-4-hydroxybenzyl)-isocyanurate, 3,9-bis[2-[3-(3-t-butyl-4-hydroxy-5-methylphenyl)propionyloxy]-1,1-dimethylethyl]-2,4,8,10-tetraoxaspiro[5.5]undecane, 2,6-di-tert-butyl-p-cresol (BHT), 1,3,5-tris(3,5-di-tert-butyl-4-hydroxybenzyl)-1,3,5-triazine-2,4,6(1H,3H,5H)-trione [manufactured by ADEKA CORPORATION, AO-020], 4,4',4"-(1-methylpropanyl-3-ylidene)tris(6-tert-butyl-m-cresol) [manufactured by ADEKA CORPORATION, AO-030], 6,6'-di-tert-butyl-4,4'-butylidenedi-m-cresol [manufactured by ADEKA CORPORATION, AO-040], and 1,3,5-tris(3,5-di-tert-butyl-4-hydroxyphenylmethyl)-2,4,6-trimethylbenzene [manufactured by ADEKA CORPORATION, AO-330].

Examples of the hindered amine-based compound include 2,2,6,6-tetramethyl-4-hydroxypiperidine-1-oxyl [manufactured by ADEKA CORPORATION, ADK STAB LA-7RD], IRGASTAB UV 10(4,4'-[1,10-dioxo-1,10-decanediyl)bis(oxy)]bis[2,2,6,6-tetramethyl]-1-piperidinyloxy) (CAS.2516-92-9) and TINUVIN 123 (4-hydroxy-2,2,6,6,-tetramethylpiperidine-N-oxyl) (all manufactured by BASF), FA-711HM and FA-712HM (2,2,6,6-tetramethylpiperidinyl methacrylate, manufactured by Showa Denko Materials Co., Ltd.), TINUVIN 111FDL, TINUVIN 144, TINUVIN 152, TINUVIN 292, TINUVIN 765, TINUVIN 770DF, TINUVIN 5100, SANOL LS-2626, CHIMASSORB 119FL, CHIMASSORB 2020 FDL, CHIMASSORB 944 FDL, and TINUVIN 622 LD (all manufactured by BASF), and LA-52, LA-57, LA-62, LA-63P, LA-68LD, LA-77Y, LA-77G, LA-81, LA-82 (1,2,2,6,6-pentamethyl-4-piperidyl methacrylate), and LA-87 (all manufactured by ADEKA CORPORATION).

When the present composition contains an antioxidant, for example, the content ratio of the antioxidant is preferably 0.001 parts by mass or more and 10 parts by mass or less with respect to 100 parts by mass of the total solid content of the polymer (A) and the compound (B).

[Inorganic Filler]

Examples of the inorganic filler include silicas such as natural silica, fused silica, and amorphous silica, white carbon, titanium white, aerosil, alumina, talc, natural mica, synthetic mica, clay, barium sulfate, E-glass, A-glass, C-glass, L-glass, D-glass, S-glass, S-glass, and M-glass G20.

When the present composition contains an inorganic filler, for example, the content ratio of the inorganic filler is preferably 0.1 parts by mass or more and 300 parts by mass or less with respect to 100 parts by mass of the total solid content of the polymer (A) and the compound (B). The inorganic filler may be in a state of being dispersed in the solvent by the polymer (A).

[Organic Filler]

Examples of the organic filler include fluorine-based resins, such as polytetrafluoroethylene (PTFE), a polyperfluoroalkoxy resin, a polyfluorinated ethylene propylene resin, and a polytetrafluoroethylene-polyethylene copolymer, or fluorine-based particles, polystyrene resins or particles, rubber-like resins, such as polybutadiene and a styrene-butadiene resin, or particles, and hollow particles having divinylbenzene or divinylbiphenyl as a shell.

When the present composition contains an organic filler, for example, the content ratio of the organic filler is preferably 0.1 parts by mass or more and 300 parts by mass or less with respect to 100 parts by mass of the total solid

content of the polymer (A) and the compound (B). The organic filler may be in a state of being dispersed in the solvent by the polymer (A).

[Physical Properties of Present Composition]

The resin flow amount of the present composition is preferably 0% or more and more preferably 10% or more, and is preferably 25% or less and more preferably 20% or less.
When the resin flow amount is in the above range, film thickness uniformity of, for example, a prepreg or a copper-clad laminate obtained using the present composition is improved.
Specifically, the resin flow amount is measured by the method described in the following Examples.

[Method for Preparing Present Composition]

The present composition can be prepared, for example, by uniformly mixing the polymer (A), the compound (B), and the other components.
There is no particular limitation in, for example, the order of mixing and mixing conditions in this case, and a conventionally known mixer may be used for mixing.

<<Cured Product>>

A cured product according to one embodiment of the present invention (hereinafter, also referred to as "present cured product") is a cured product of the present composition, and is obtained by curing the present composition.
The present cured product may be, for example, a partially cured product of the present composition obtained by drying a solvent from the present composition.
A method of curing the present composition is not particularly limited, but usually, a method of thermally curing the present composition by heating or a method of photocuring the present composition by irradiation with light is used. These methods can also be used in combination.
In the case of thermal curing, the heating temperature is preferably 50°C or higher, more preferably 100°C or higher, and still more preferably 120°C or higher, and is preferably 250°C or lower and more preferably 220°C or lower. The heating time is preferably 0.1 hours or longer and more preferably 0.5 hours or longer, and is preferably 36 hours or shorter and more preferably 5 hours or shorter.
In the case of photocuring, examples of the light to be irradiated include visible light, ultraviolet light, near infrared light, and far infrared light.

· Glass Transition Temperature (Tg)

The lower limit of Tg of the present cured product is preferably 100°C and more preferably 110°C, and the upper limit thereof is, for example, 300°C.
When Tg is in the above range, melt molding can be more easily performed, and a cured product excellent in heat resistance can be easily obtained.
Tg was measured by preparing a test piece (width: 3 mm × length: 1 cm), measuring Tg at a temperature increase rate of 10°C/min from 50°C to 300°C and at 1 Hz under nitrogen using a dynamic viscoelasticity measuring device (manufactured by Seiko Instruments Inc., Model No.: "EXSTAR4000"), and measuring Tg at a temperature increase rate of 10°C/min to 300°C at 1 Hz, and tanδ at this time was taken as the glass transition temperature (Tg). When two or more tanδ values were present, the lowest value was defined as Tg.
The loss tangent (tanδ) of the present cured product is preferably 0.0025 or less, more preferably 0.0018 or less, and still more preferably 0.0015 or less, and the lower limit thereof is not particularly limited, and is preferably 0.0005 or more, from the viewpoint that, for example, the transmission loss can be reduced.
Specifically, the loss tangent can be measured by the method described in the following Examples.
The shape of the present cured product is not particularly limited, and may be a shape suitable for, for example, use application and purpose, and examples thereof include a film.
For example, the present composition can be obtained as a film-shaped cured product by melt-molding or cast-molding the present composition.
The thickness of the film is not particularly limited, and may be appropriately selected according to a desired use application, but is, for example, 10 um or more and preferably 30 um or more, and is, for example, 2 mm or less and preferably 1 mm or less.

<<Laminate>>

A laminate according to one embodiment of the present invention (hereinafter, also referred to as "present laminate") includes, for example, a substrate and a cured layer formed using the present composition.
The present laminate may include two or more layers of substrates, two or more layers of cured layers, or conventionally known layers other than the substrate and the cured layer. When the present laminate has two or more layers of substrates, cured layers, and other layers, these layers may be the same layer (plate) or different layers (plates).
The present laminate may be a prepreg obtained by impregnating a substrate such as a glass cloth, an aramid nonwoven fabric, or a polyester nonwoven fabric with the present composition and curing the resultant.
Examples of the substrate include an inorganic substrate, a metal substrate, and a resin substrate from the viewpoint of adhesiveness and practical use. The substrate may be a prepreg.
Examples of the inorganic substrate include inorganic substrates containing, for example, silicon, silicon carbide, silicon nitride, alumina, glass, or gallium nitride as a component.
Examples of the metal substrate include metal substrates containing, for example, copper, aluminum, gold, silver, nickel, or palladium as a component.
Examples of the resin substrate include resin substrates containing, for example, a liquid crystal polymer, polyimide, polyphenylene sulfide, polyether ether ketone, polyamide (nylon), polyethylene terephthalate, polyethylene naphthalate, a cycloolefin polymer, or polyolefin as a component.
The cured layer can be formed, for example, by curing according to the method described in the section of the cured product.
The thickness of the cured layer is not particularly limited, and is, for example, 1 um to 3 mm.

<<Use Application>>

The polymer (A), the present composition, the present cured product, and the present laminate can be suitably used for, for example, structural materials used in the transportation industry such as the aircraft industry and the automobile industry, electrical and electronic materials used in the electrical and electronic industry. Specifically, for example, the polymer (A), the present composition, the present cured product, and the present laminate can be suitably used for a sealing material for an electrical and electronic component, an interlayer insulating film, and a stress relaxation primer; laminate use applications (for example: a prepreg, a copper-clad laminate, a (multilayer) printed wiring board, an interlayer adhesive, a solder resist, and a solder paste); adhesive use applications (for example: an adhesive sheet for forming an insulating layer, a thermally conductive adhesive, and an adhesive sheet); structural adhesives/prepregs used for various structural materials; various coatings and optical component use applications (for example: optical films such as wave plates and retardation plates, various special lenses such as conical lenses, spherical lenses, and cylindrical lenses, and lens arrays), and insulating films for printed wiring boards.

<<Electronic Component>>

An electronic component according to one embodiment of the present invention includes the present cured product or the present laminate. The electronic component may include two or more present cured products or two or more present laminates, or may include one or more present cured product and one or more present laminate. When the electronic component includes two or more present cured products or present laminates, these present cured products or present laminates may be the same as or different from each other.
Examples of the electronic component include a circuit board, a semiconductor package, and a display board. The present cured product (cured film) can be used as a prepreg, a copper-clad laminate, a printed wiring board, an adhesive sheet for forming an insulating layer, a surface protective film, a rewiring layer, or a planarization film of these electronic components. Since the present cured product can maintain insulation even under high temperature and high humidity, the electronic component can protect a circuit pattern from an external environment such as dust, heat, and moisture, has excellent insulation reliability between circuit patterns, and can stably operate for many years.
For example, the rewiring layer can be formed by filling of the pattern of the present cured product (cured film) with a metal, for example, by plating, further, as necessary, repeating laminating the present cured product (cured film) and filling with a metal, whereby an electronic component having a substrate and a rewiring layer including a metal wiring and an insulating film can be manufactured.

## Examples

The present invention will now be described specifically based on Examples, but the present invention is not limited to the following Examples.

[Synthesis Example 1]

In a four-neck separable flask equipped with a stirrer, 1,1-bis(4-hydroxyphenyl)-3,3,5-trimethylcyclohexane (86.92 g), 4,6-dichloropyrimidine (47.58 g), isopropenylphenol (10.67 g), and potassium carbonate (50.66 g) were weighed, N-methyl-2-pyrrolidone (64.00 g) was added thereto, and the mixture was reacted at 130°C for 6 hours in a nitrogen atmosphere. After completion of the reaction, N-methyl-2-pyrrolidone (368.0 g) was added for dilution, and the solution after removal of the salt by filtration was charged into methanol (19.4 kg). The precipitated solid was filtered off, and the solid was washed with a small amount of methanol, filtered off again to recover the solid, and then dried at 120°C for 12 hours under reduced pressure using a vacuum dryer to obtain a polymer represented by the following Formula (1) (yield: 122.0 g, 90%).

[Chem. 22]

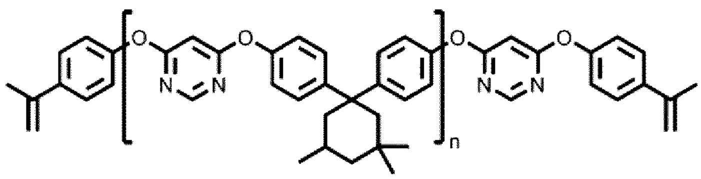

(1)

[Synthesis Example 2]

A polymer represented by the following Formula (2) was obtained (yield: 80.08 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (62.08 g), isopropenylphenol (2.170 g), 4,6-dichloropyrimidine (30.99 g), and potassium carbonate (38.83 g).

[Chem. 23]

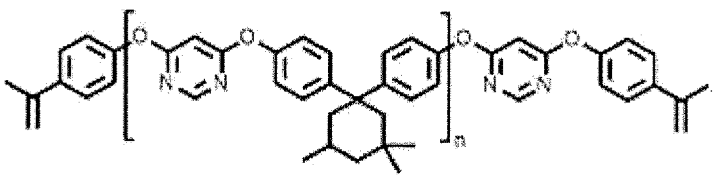

(2)

[Synthesis Example 3]

A polymer represented by the following Formula (3) was obtained (yield: 121.9 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (86.92 g), 4,6-dichloropyrimidine (47.58 g), 2-allylphenol (10.67 g), and potassium carbonate (59.66 g).

[Chem. 24]

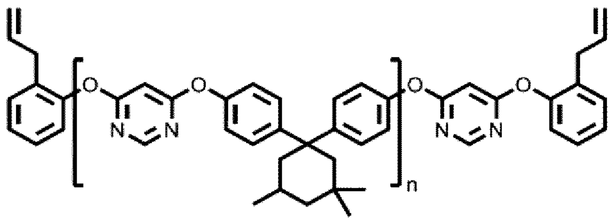

(3)

[Synthesis Example 4]

In a four-neck separable flask equipped with a stirrer, 1,1-bis(4-hydroxyphenyl)-3,3,5-trimethylcyclohexane (86.92 g), 4,6-dichloropyrimidine (47.58 g), and potassium carbonate (59.66 g) were weighed, N-methyl-2-pyrrolidone (64.00 g) was added thereto, and the mixture was reacted at 130°C for 6 hours in a nitrogen atmosphere. After the reaction, allyl bromide (10.67 g) was added dropwise while the vessel was cooled to 10°C, and then the reaction was performed at 70°C for 6 hours. After removal of the salt by filtration from a solution obtained by adding N-methyl-2-pyrrolidone (368.0 g) for dilution to the obtained reaction solution, the obtained solution was charged into methanol (19.40 kg). The precipitated solid was filtered off, and the solid was washed with a small amount of methanol, filtered off again to recover the solid, and then dried at 120°C for 12 hours under reduced pressure using a vacuum dryer to obtain a polymer represented by the following Formula (4) (yield: 121.9 g, 90%).

[Chem. 25]

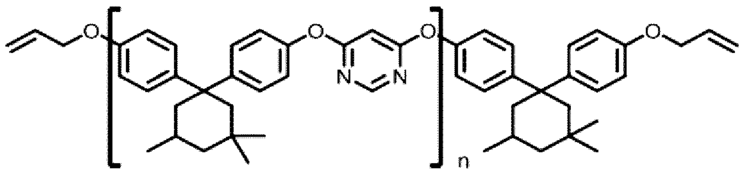

(4)

[Synthesis Example 5]

In a four-neck separable flask equipped with a stirrer, 1,1-bis(4-hydroxyphenyl)-3,3,5-trimethylcyclohexane (71.13 g), 4,6-dichloropyrimidine (29.79 g), and potassium carbonate (39.27 g) were weighed, N-methyl-2-pyrrolidone (64.00 g) was added thereto, and the mixture was reacted at 130°C for 6 hours in a nitrogen atmosphere. After the reaction, methacryloyl chloride (6.094 g) was added dropwise while the vessel was cooled to 10°C, and then the reaction was performed at 50°C for 6 hours. After removal of the salt by filtration from a solution obtained by adding N-methyl-2-pyrrolidone (368.0 g) for dilution to the obtained reaction solution, the obtained solution was charged into methanol (19.40 kg). The precipitated solid was filtered off, and the solid was washed with a small amount of methanol, filtered off again to recover the solid, and then dried at 120°C for 12 hours under reduced pressure using a vacuum dryer to obtain a polymer represented by the following Formula (5) (yield: 92.30 g, 90%).

[Chem. 26]

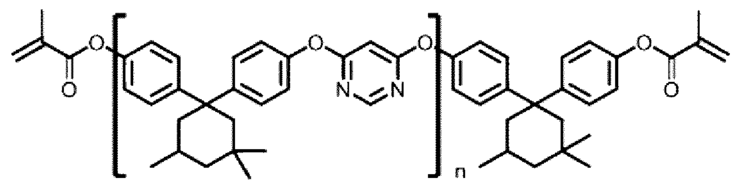

(5)

[Synthesis Example 6]

A polymer represented by the following Formula (6) was obtained (yield: 77.04 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (58.98 g), 2,2'-diallylbisphenol A (3.084 g), 2-phenylphenol (2.764 g), 4,6-dichloropyrimidine (30.99 g), and potassium carbonate (37.317 g).

[Chem. 27]

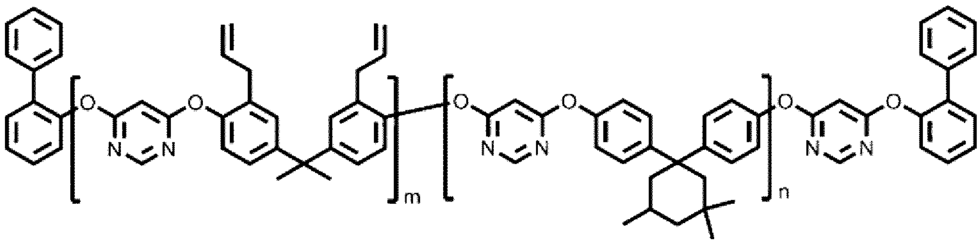

(6)

[Synthesis Example 7]

A polymer represented by the following Formula (7) was obtained (yield: 68.70 g, 90%) by performing synthesis in the same procedure as in Synthesis Example 1, except that the raw materials and the alkali metal compound used were changed to 2,2-bis(4-hydroxy-3-methylphenyl)propane (51.26 g), isopropenylphenol (7.834 g), 4,6-dichloropyrimidine (34.10 g), and potassium carbonate (35.93 g).

[Chem. 28]

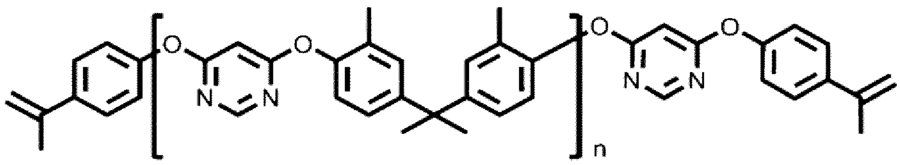

(7)

[Synthesis Example 8]

A polymer represented by the following Formula (8) was obtained (yield: 86.10 g, 90%) by performing synthesis in the same procedure as in Synthesis Example 1, except that the raw materials and the alkali metal compound used were changed to 2,2-bis(4-hydroxy-3-methylphenyl)propane (51.27 g), isopropenylphenol (7.83 g), 4,6-dichloro-2-phenylpyrimidine (51.51 g), and potassium carbonate (35.93 g).

[Chem. 29]

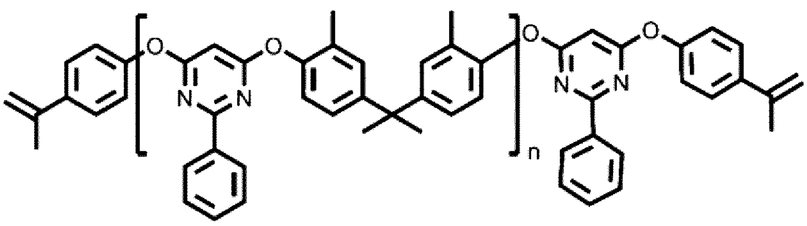

(8)

[Synthesis Example 9]

A polymer represented by the following Formula (9) was obtained (yield: 77.00 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (58.98 g), 4-chloropyrimidine (1.145 g), 4,6-dichloropyrimidine (29.34 g), and potassium carbonate (37.31 g).

[Chem. 30]

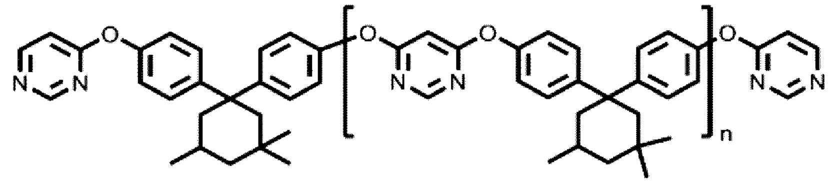

(9)

[Synthesis Example 10]

A polymer represented by the following Formula (10) was obtained (yield: 70.00 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (46.56 g), 4,6-dichloropyrimidine (21.45 g), and potassium carbonate (22.80 g).

[Chem. 31]

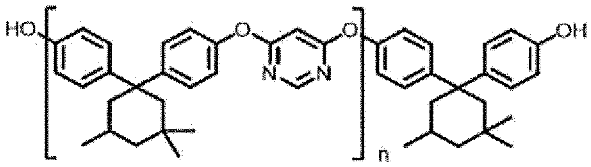

(10)

[Synthesis Example 11]

A polymer for evaluating a loss tangent represented by the above Formula (10) and having a weight average molecular weight Mw of 50,000 was obtained (yield: 70 g, 90%) by performing in the same procedure as in Synthesis Example 1, except that the raw materials and the alkali metal compound used were changed to 1,1-bis(4-hydroxyphenyl)-3,3,5-trimethylcyclohexane (56.237 g, 181.15 mmol), 4,6-dichloropyrimidine (26.959 g, 180.97 mmol), and potassium carbonate (33.800 g, 244.56 mmol).

[Synthesis Example 12]

In a four-neck separable flask equipped with a stirrer, 2,2-bis(4-hydroxy-3-methylphenyl)propane (26.43 g), 4,6-dichloro-2-phenylpyrimidine (17.08 g), and potassium carbonate (19.23 g) were weighed, N-methyl-2-pyrrolidone (42.50 g) was added thereto, and the mixture was reacted at 100°C for 6 hours in a nitrogen atmosphere. After the reaction, m,p-(chloromethyl)styrene (11.53 g) was added dropwise while the vessel was cooled to 10°C, and then the reaction was performed at 100°C for 4 hours. After removal of the salt by filtration from a solution obtained by adding N-methyl-2-pyrrolidone (55.0 g) for dilution to the obtained reaction solution, the obtained solution was charged into methanol (6900 g). The precipitated solid was filtered off, and the solid was washed with a small amount of methanol, filtered off again to recover the solid, and then dried at 60°C for 12 hours under reduced pressure using a vacuum dryer to obtain a polymer represented by the following Formula (11) (yield: 44.10 g, 90%).

[Chem. 32]

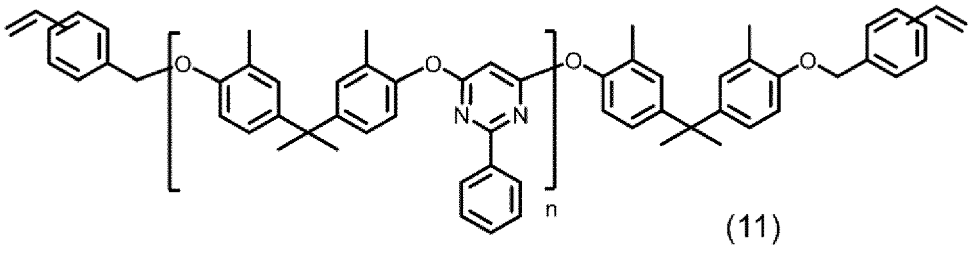

(11)

[Synthesis Example 13]

A polymer represented by the following Formula (12) was obtained (yield: 46.55 g, 90%) by performing synthesis in the same procedure as in Synthesis Example 12, except that the raw materials and the alkali metal compound used were changed to 1,1-bis(4-hydroxy-3-methylphenyl)-3,3,5-trimethylcyclohexane (33.85 g), 4,6-dichloro-2-phenylpyrimidine (16.66 g), m,p-chloromethylstyrene (8.680 g), potassium carbonate (18.66 g), and N-methyl-2-pyrrolidone (42.50 g).

[Chem. 33]

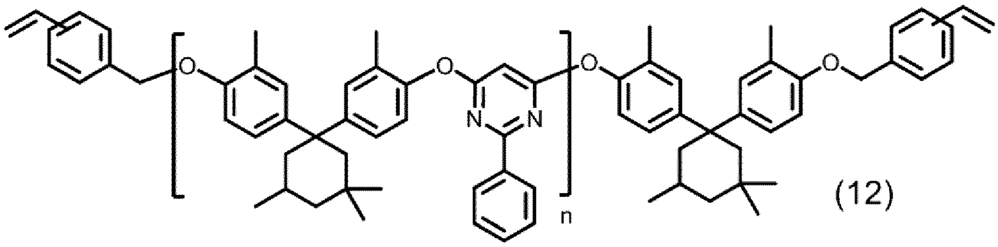

(12)

[Synthesis Example 14]

A polymer represented by the following Formula (13) was obtained (yield: 89.30 g, 90%) by performing synthesis in the same procedure as in Synthesis Example 12, except that the raw materials and the alkali metal compound used were changed to 2,2-bis(4-hydroxy-3-methylphenyl)propane (25.63 g), 9,9-bis(4-hydroxy-3-methylphenyl)fluorene (37.84 g), 4,6-dichloro-2-phenylpyrimidine (33.31 g), m,p-chloromethylstyrene (17.36 g), potassium carbonate (37.31 g), and N-methyl-2-pyrrolidone (181.4 g).

[Chem. 34]

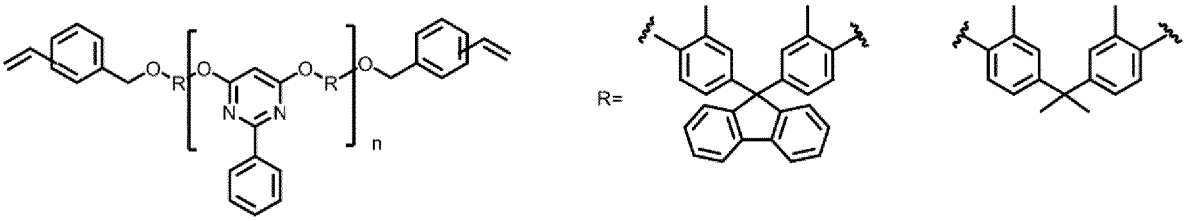

R=

(1 3)

[Synthesis Example 15]

A polymer represented by the following Formula (14) was obtained (yield: 39.69 g, 88%) by performing synthesis in the same procedure as in Synthesis Example 12, except that the raw materials and the alkali metal compound used were changed to 2,2-bis(4-hydroxy-3-methylphenyl)propane (25.63 g), 4,6-dichloro-2-phenylpyrimidine (13.50 g), m,p-(chloromethyl)styrene (16.96 g), potassium carbonate (18.66 g), and N-methyl-2-pyrrolidone (78.28 g).

[Chem. 35]

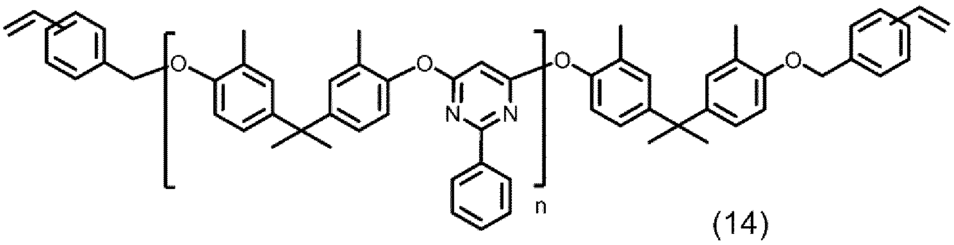

(14)

[Synthesis Example 16]

A polymer represented by the following Formula (15) was obtained (yield: 37.91 g, 90%) by performing synthesis in the same procedure as in Synthesis Example 12, except that the raw materials and the alkali metal compound used were changed to 2,2-bis(4-hydroxy-3-methylphenyl)propane (25.63 g), 4,6-dichloro-2-phenylpyrimidine (19.81 g), m,p-(chloromethyl)styrene (5.087 g), potassium carbonate (18.66 g), and N-methyl-2-pyrrolidone (78.28 g).

[Chem. 36]

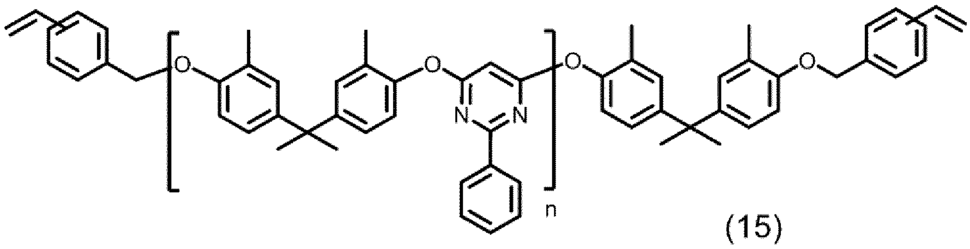

(15)

[Synthesis Example 17]

A polymer represented by the following Formula (16) was obtained (yield: 40.55 g, 90%) by performing synthesis in the same procedure as in Synthesis Example 12, except that the raw materials and the alkali metal compound used were changed to 2,2-bis(4-hydroxy-3-methylphenyl)propane (26.43 g), 4,6-dichloro-2-phenylpyrimidine (17.08 g), potassium carbonate (19.23 g), and N-methyl-2-pyrrolidone (42.50 g).

[Chem. 37]

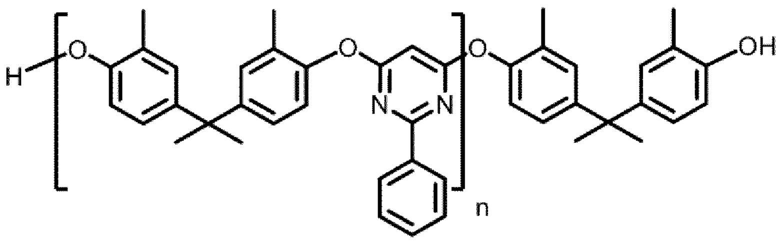

(1 6)

[Synthesis Example 18]

A polymer represented by the following Formula (17) was obtained (yield: 76.44 g, 89%) was obtained by performing synthesis in the same procedure as in Synthesis Example 14, except that the raw materials and the alkali metal compound used were changed to 2,2-bis(4-hydroxy-3-methylphenyl)propane (25.63 g), 9,9-bis(4-hydroxy-3-methylphenyl)fluorene (37.84 g), 4,6-dichloro-2-phenylpyrimidine (33.31 g), potassium carbonate (37.31 g), and N-methyl-2-pyrrolidone (181.4 g).

[Chem. 38]

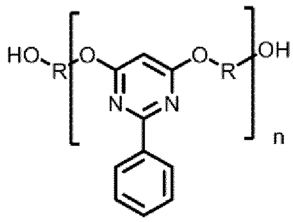

R=

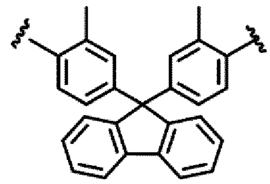

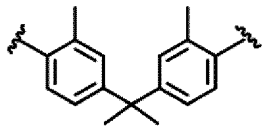

(17)

[Synthesis Example 19]

A polymer represented by the following Formula (18) was obtained (yield: 45.05 g, 90%) was obtained by performing synthesis in the same procedure as in Synthesis Example 17, except that the raw materials and the alkali metal compound used were changed to 1,1-bis(4-hydroxy-3-methylphenyl)-3,3,5-trimethylcyclohexane (33.85 g), 4,6-dichloro-2-phenylpyrimidine (16.65 g), potassium carbonate (18.65 g), and N-methyl-2-pyrrolidone (50.5 g).

[Chem. 39]

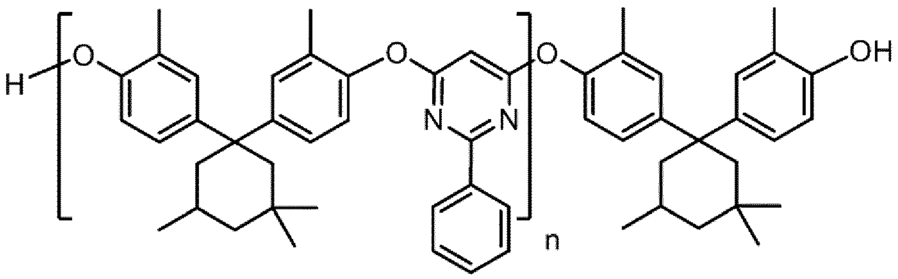

(18)

[Synthesis Example 20]

A polymer represented by the following Formula (19) was obtained (yield: 48.19 g, 90%) by performing synthesis in the same procedure as in Synthesis Example 1, except that the raw materials and the alkali metal compound used were changed to 2,2-bis(4-hydroxy-3-methylphenyl)propane (25.63 g), 4,6-dichloro-2-phenylpyrimidine (29.25 g), 2-allylphenol (8.131 g), and potassium carbonate (24.31 g).

[Chem. 40]

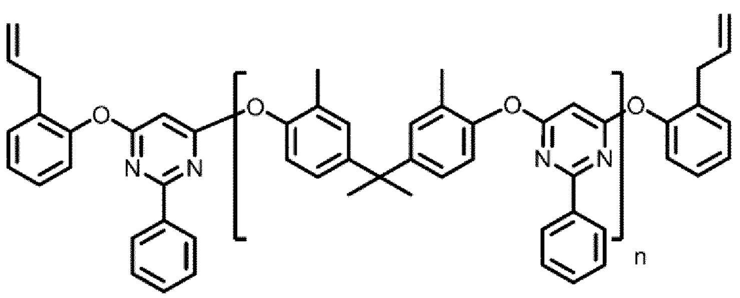

(19)

[Synthesis Example 21]

A polymer represented by the following Formula (20) was obtained (yield: 34.71 g, 85%) by performing synthesis in the same procedure as in Synthesis Example 5, except that the raw materials and the alkali metal compound used were changed to 2,2-bis(4-hydroxy-3-methylphenyl)propane (25.63 g), 4,6-dichloropyrimidine (16.57 g), potassium carbonate (18.65 g), N-methyl-2-pyrrolidone (64.00 g), and methacryloyl chloride (7.657 g).

[Chem. 41]

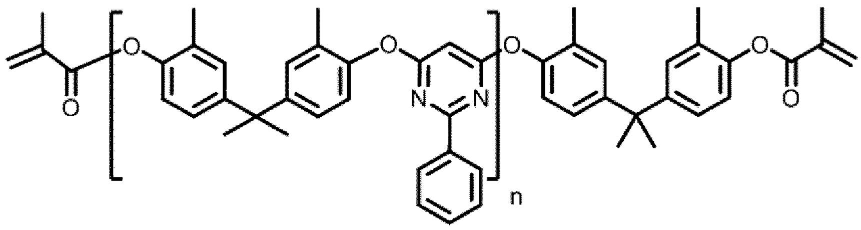

(20)

[Synthesis Example 22]

A polymer represented by the following Formula (21) was obtained (yield: 44.71 g, 90%) by performing synthesis in the same procedure as in Synthesis Example 1, except that the raw materials and the alkali metal compound used were changed to 1,1-bis(4-hydroxyphenyl)-3,3,5-trimethylcyclohexane (31.04 g), 2,2'-diallylbisphenol A (7.711 g), 4-chloropyrimidine (5.267 g), 4,6-dichloropyrimidine (21.33 g), and potassium carbonate (27.61 g).

[Chem. 42]

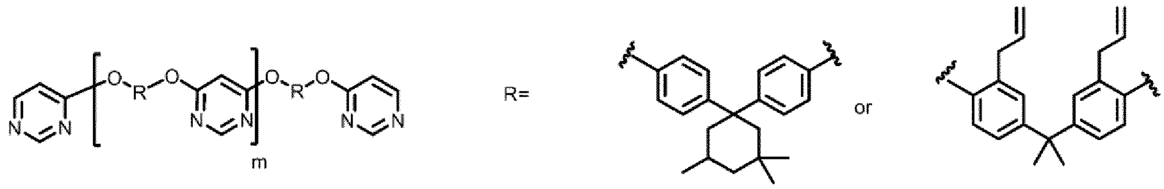

(21)

[Weight Average Molecular Weight (Mw) and Number Average Molecular Weight (Mn)]

The weight average molecular weight (Mw) and the number average molecular weight (Mn) of the polymers synthesized in Synthesis Examples 1 to 10 and 12 to 22 and SA-9000 used in Comparative Example described below were measured under the following conditions using a GPC apparatus ("HLC-8320" manufactured by Tosoh Corporation). The results are shown in Tables 1 and 2.

· Column: obtained by connecting "TSKgel α-M" manufactured by Tosoh Corporation "TSKgel guard column α" manufactured by Tosoh Corporation
· Developing solvent: N-methyl-2-pyrrolidone
· Column temperature: 40°C
· Flow rate: 1.0 mL/min
· Sample concentration: 0.75 mass%
· Sample injection amount: 50 μL
· Detector: refractometer
· Standard substance: monodisperse polystyrene
· Concentration of measurement sample: 0.1 mass%

<Loss Tangent>

Samples obtained by blending the polymers to be measured (the polymers synthesized in Synthesis Examples 1 to 10 and 12 to 22 and SA-9000) and the polymer synthesized in Synthesis Example 11 at 90 : 10, 75 : 25, and 50 : 50, respectively, were spin-coated on a substrate, and fired in an oven under nitrogen conditions at 100°C for 5 minutes and further at 250°C for 1 hour.

Using the obtained fired product, the loss tangent at 10 GHz was measured using a cavity resonator method (dielectric constant measurement system TE mode resonator manufactured by AET, Inc.). The loss tangent of the polymer to be measured was calculated from the extrapolated value of the relationship between the obtained result of the loss tangent and the content ratio of the polymer to be measured. The results are shown in Tables 1 and 2.

[Table 1]

Table 1

| | Synthesis Example 1 | Synthesis Example 2 | Synthesis Example 3 | Synthesis Example 20 | Synthesis Example 4 | Synthesis Example 5 | Synthesis Example 21 |
|---|---|---|---|---|---|---|---|
| Mn | 3200 | 8800 | 3200 | 1600 | 3700 | 3200 | 1500 |
| Mw | 8000 | 24000 | 7900 | 4000 | 7300 | 7400 | 4000 |
| Loss tangent | 0.002 | 0.002 | 0.002 | 0.001 | 0.002 | 0.003 | 0.002 |
| | Synthesis Example 6 | Synthesis Example 7 | Synthesis Example 8 | Synthesis Example 9 | Synthesis Example 22 | Synthesis Example 10 | SA-9000 |
| Mn | 9100 | 3000 | 3000 | 3100 | 1600 | 10000 | 2000 |
| Mw | 25000 | 7500 | 7500 | 7000 | 4000 | 25000 | 4100 |
| Loss tangent | 0.002 | 0.002 | 0.001 | 0.002 | 0.002 | 0.004 | 0.004 |

<Glass Transition Temperature (Tg) of Polymer>

A varnish for evaluation was prepared by mixing 100 parts by mass of the polymers to be measured (the polymers synthesized in Synthesis Examples 12 to 19 and SA-9000), 0.5 parts by mass of PERCUMYL D (manufactured by NOF CORPORATION), and 100 parts by mass of toluene, and then the prepared varnish for evaluation was applied onto a copper foil (TQ-M4-VSP (manufactured by MITSUI MINING & SMELTING CO., LTD.)) using a baker-type applicator (gap: 75 um) and dried at 100°C for 5 minutes to form a coating film. A copper foil (TQ-M4-VSP (manufactured by MITSUI MINING & SMELTING CO., LTD.)) was overlaid on the obtained coating film, and vacuum-pressed at 150°C for 5 minutes, and then fired at 200°C for 2 hours under nitrogen to prepare a cured film with a copper foil. The prepared cured film with a copper foil was immersed in a 40 mass% iron chloride solution to remove the copper foil from the cured film with a copper foil, then washed with water, and dried at 80°C for 30 minutes to prepare a film for measuring a glass transition temperature (Tg). The results are shown in Table 2.

A test piece (width: 3 mm × length: 1 cm) was cut out from the prepared film for measuring Tg, and measured at a temperature increase rate of 10°C/min from 50°C to 300°C and at 1 Hz using a dynamic viscoelasticity measuring device (manufactured by Seiko Instruments Inc., Model No.: "EXSTAR4000"), and tanδ at this time was taken as the glass transition temperature (Tg).

<Peel Strength of Polymer>

A varnish for evaluation was prepared by mixing 100 parts by mass of the polymers to be measured (the polymers synthesized in Synthesis Examples 12 to 19 and SA-9000), 0.5 parts by mass of PERCUMYL D (manufactured by NOF CORPORATION), and 100 parts by mass of toluene, and then the prepared varnish for evaluation was applied onto a copper foil (TQ-M4-VSP (manufactured by MITSUI MINING & SMELTING CO., LTD.)) using a baker-type applicator (gap: 75 um), heated at 100°C for 5 minutes, and then dried at 130°C for 5 minutes to form a coating film. A copper foil (TQ-M4-VSP (manufactured by MITSUI MINING & SMELTING CO., LTD.)) was overlaid on the obtained coating film, and vacuum-pressed at 150°C for 5 minutes, and then fired at 200°C for 2 hours under nitrogen to prepare a cured film with a copper foil, and the cured film with a copper foil was used as a sample for peel strength.

A test piece (width: 5 mm × length: 10 cm) was cut out from the prepared sample for peel strength, the copper foil with the cured film (a laminated portion of one copper foil and the cured film in the sample for peel strength) was pulled in a 90-degree direction under a condition of 500 mm/min by using "Instron 5567" manufactured by Instron, and the peel strength was measured in accordance with "IPC-TM-650 2.4.9". The results are shown in Table 2.

[Table 2]

Table 2

| Resin | Example | | | | |
|---|---|---|---|---|---|
| | Synthesis Example 12 | Synthesis Example 13 | Synthesis Example 14 | Synthesis Example 15 | Synthesis Example 16 |
| Mn | 1600 | 1600 | 1800 | 800 | 3200 |
| Mw | 3400 | 3400 | 4000 | 2000 | 8000 |
| Loss tangent | 0.0010 | 0.0012 | 0.0009 | 0.0012 | 0.0010 |
| Tg (°C) | > 130 | > 130 | > 130 | > 130 | > 130 |
| Peel strength (N/mm) | 0.5 | 0.5 | 0.5 | 0.5 | 0.5 |

| Resin | Comparative Example | | | |
|---|---|---|---|---|
| | Synthesis Example 17 | Synthesis Example 18 | Synthesis Example 19 | SA-9000 |
| Mn | 1500 | 1600 | 1700 | 2000 |
| Mw | 3400 | 4000 | 4250 | 4100 |

(continued)

| Resin | Comparative Example | | | |
|---|---|---|---|---|
| | Synthesis Example 17 | Synthesis Example 18 | Synthesis Example 19 | SA-9000 |
| Loss tangent | 0.0040 | 0.0030 | 0.0030 | 0.0040 |
| Tg (°C) | Unmeasurable | Unmeasurable | Unmeasurable | > 130 |
| Peel strength (N/mm) | Unmeasurable | Unmeasurable | Unmeasurable | 0.5 |

[Examples 1 to 14 and 29 to 31, and Comparative Examples 1 to 7 and 18]

Each component described in the section of composition type shown in Tables 3-1, 3-2, and 4 was mixed with a mix rotor to have the ratio (parts by mass) described in the section of composition blending ratio shown in Tables 3-1, 3-2, and 4, and the concentration was adjusted with toluene so that the concentration of the solid content was 50 parts by mass to prepare a composition.

<Resin Flow Evaluation>

Each component described in the section of composition type shown in Tables 3-1, 3-2, and 4 was mixed with a mix rotor to have the ratio (parts by mass) described in the section of composition blending ratio shown in Tables 3-1, 3-2, and 4, and 67 mass% of toluene was added to 100 mass% of the mixture to prepare a varnish. A glass cloth (Toyobo NE Glass, #1027) was immersed in the prepared varnish for 2 minutes, taken out from the varnish, and then dried at 100°C for 5 minutes and then at 160°C for 10 minutes to prepare a prepreg. A copper foil (TQ-M4-VSP (manufactured by MITSUI MINING & SMELTING CO., LTD., 10 × 10 cm) was overlaid on both surfaces of the prepared prepreg (10 × 10 cm), and vacuum-pressed at room temperature and 3 MPa, then heated to 200°C at 10°C/min, and held at 200°C for 2 hours to prepare a copper-clad laminate (10 × 10 cm). The resin protruding from the prepared copper-clad laminate (10 × 10 cm) was cut out, and the mass of the protruding resin was measured. The resin flow (%) was calculated by the following calculation formula.

$$\text{Resin flow (\%)} = \text{mass of resin protruding after pressing/mass of prepreg} \times 100$$

<Preparation of Cured Film>

The composition obtained in each of Examples and Comparative Examples was applied onto a copper foil (TQ-M4-VSP (manufactured by MITSUI MINING & SMELTING CO., LTD.)) using a baker-type applicator (gap: 125 um), and then dried at 100°C for 5 minutes, and in the case of using the composition obtained in Example 4 or Comparative Example 2, the composition was fired at 120°C for 1.5 hours under nitrogen and then fired at 250°C for 3 hours under nitrogen, and in the case of the composition obtained in each of Examples and Comparative Examples other than Example 4 and Comparative Example 2, the composition was fired at 120°C for 1.5 hours under nitrogen and then fired at 180°C for 3 hours under nitrogen.

The obtained cured film with a copper foil was immersed in a 40 mass% iron chloride solution to remove the copper foil, then washed with water, and dried in an oven at 80°C for 30 minutes to prepare a cured film.

<Preparation of Laminate>

The composition obtained in each of Examples and Comparative Examples was applied onto a Kapton film (150EN-C (manufactured by DU PONT-TORAY CO., LTD.)) using a baker-type applicator (gap: 12.5 um), and dried at 100°C for 5 minutes. A copper foil (TQ-M4-VSP (manufactured by MITSUI MINING & SMELTING CO., LTD.)) having a thickness of 12 um was disposed on the coating film of the laminate of the obtained coating film and the Kapton film, the coating film and the copper foil were bonded together under the conditions of 150°C and 0.3 m/min using a thermal

laminator (VA-700 (manufactured by TAISEI LAMINATOR CO,. LTD.)), and then in the case of using the composition obtained in Example 4 or Comparative Example 2, the composition was fired at 120°C for 1.5 hours under nitrogen and then fired at 250°C for 3 hours under nitrogen, and in the case of the composition obtained in each of Examples and Comparative Examples other than Example 4 and Comparative Example 2, the composition was fired at 120°C for 1.5 hours under nitrogen and then fired at 180°C for 3 hours under nitrogen, thereby preparing a laminate.

<Loss Tangent>

A test piece (width: 6 cm × length: 6 cm) was cut out from the prepared cured film, and the loss tangent of the test piece at 10 GHz was measured using a cavity resonator method (dielectric constant measurement system TE mode resonator manufactured by AET, Inc.). The results are shown in Tables 3-1, 3-2, and 4.

<Peel Strength>

A test piece (width: 5 mm × length: 10 cm) was cut out from the prepared laminate, the Kapton film with a cured film was pulled in a 90-degree direction under a condition of 500 mm/min by using "Instron 5567" manufactured by Instron, and the peel strength between the cured film and the copper foil was measured in accordance with "IPC-TM-650 2.4.9". The results are shown in Tables 3-1, 3-2, and 4.

<Glass Transition Temperature (Tg)>

A test piece (width: 3 mm × length: 1 cm) was cut out from the prepared cured film, and measured at a temperature increase rate of 10°C/min from 50°C to 300°C and at 1 Hz using a dynamic viscoelasticity measuring device (manufactured by Seiko Instruments Inc., "EXSTAR4000"), and tanδ at this time was taken as the glass transition temperature (Tg). The results are shown in Tables 3-1, 3-2, and 4.

When two or more tanδ values were present, the lowest value was defined as Tg.

<Chemical Resistance>

The composition obtained in each of Examples and Comparative Examples was applied onto a copper foil (TQ-M4-VSP (manufactured by MITSUI MINING & SMELTING CO., LTD.)) using a baker-type applicator (gap: 125 um), and then dried at 100°C for 5 minutes, and in the case of using the composition obtained in Example 4 or Comparative Example 2, the composition was fired at 120°C for 1.5 hours under nitrogen and then fired at 250°C for 3 hours under nitrogen, and in the case of the composition obtained in each of Examples and Comparative Examples other than Example 4 and Comparative Example 2, the composition was fired at 120°C for 1.5 hours under nitrogen and then fired at 180°C for 3 hours under nitrogen. In this way, a cured film with a copper foil was obtained, and the mass of the obtained cured film with a copper foil was measured. The mass of the copper foil before coating was weighed in advance, and the mass obtained by subtracting the previously weighed mass of the copper foil from the mass of the obtained cured film with a copper foil was regarded as "cured film mass before immersion".

The obtained cured film with a copper foil was immersed in methyl ethyl ketone (1.5 L) at room temperature for 10 minutes, and then vacuum-dried at 120°C for 3 hours to measure the mass of the cured film with a copper foil. The mass obtained by subtracting the mass of the previously weighed copper foil from the mass of the cured film with a copper foil after vacuum drying was regarded as "cured film mass after immersion".

The chemical resistance was evaluated by calculating the mass change rate by the following formula. A case where the mass change rate was 90% or more was designated as "O", and a case where the mass change rate was 90% or less was designated as "X". The results are shown in Tables 3-1, 3-2, and 4.

Mass change rate (%) = cured film mass after immersion × 100/cured film mass before immersion

<Appearance>

The appearance of the prepared cured film was visually observed, and the cured film with cracks was designated as "X", and the cured film without no cracks was designated as "O". The results are shown in Tables 3-1, 3-2, and 4.

<Impregnation Test>

A glass cloth (manufactured by Nitto Boseki Co., Ltd., #2116 type) having a size of 5 cm × 7 cm × 95 um in thickness was impregnated with the composition obtained in each of Examples and Comparative Examples, and heated and dried at 160°C for 10 minutes to obtain a prepreg having a thickness of 110 um. The obtained prepreg was observed with a digital microscope (manufactured by KEYENCE CORPORATION, VHX-6000) in a transmission mode at a magnification of 300 to observe voids between the glass cloth and the resin layer. The prepreg was bent by 180° to the long side and the short side, and the presence or absence of powder fall-off of the resin was visually observed.

A case where no void was observed and powder fall-off was not observed was designated as "O", and a case where a void was observed or powder fall-off was observed was designated as "X". The results are shown in Tables 3-1, 3-2, and 4.

[Table 3-1]

Table 3-1

| | | Example 1 | Example 2 | Example 3 | Example 4 | Example 29 |
|---|---|---|---|---|---|---|
| Composition type | Polymer-1 | Synthesis Example 1 | Synthesis Example 2 | Synthesis Example 6 | Synthesis Example 1 | Synthesis Example 1 |
| | Polymer-2 | | | | Synthesis Example 3 | Synthesis Example 20 |
| | Curable compound-1 | SLK-1500 | SLK-1500 | SLK-1500 | SLK-1500 | SLK-1500 |
| | Curable compound-2 | | | | | |
| | Initiator | DCP | DCP | DCP | DCP | DCP |
| Composition blending ratio | Polymer-1 | 50 | 50 | 50 | 25 | 25 |
| | Polymer-2 | | | | 25 | 25 |
| | Curable compound-1 | 50 | 50 | 50 | 50 | 50 |
| | Curable compound-2 | | | | | |
| | Initiator | 1.1 | 1.1 | 1.1 | 1.1 | 1.1 |
| CCL | Resin flow (%) | 20 | 15 | 20 | 15 | 15 |
| Composition properties | Loss tangent | 0.0015 | 0.0015 | 0.0016 | 0.0020 | 0.0016 |
| | Peel strength (N/mm) | 0.6 | 0.6 | 0.7 | 0.5 | 0.5 |
| | Tg(°C) | 123 | 116 | 120 | 113 | 115 |
| | Chemical resistance | ○ | ○ | ○ | ○ | ○ |
| | Appearance | ○ | ○ | ○ | ○ | ○ |
| | Impregnation test | ○ | ○ | ○ | ○ | ○ |

| | | Example 5 | Example 6 | Example 30 | Example 7 |
|---|---|---|---|---|---|
| Composition type | Polymer-1 | Synthesis Example 1 | Synthesis Example 1 | Synthesis Example 1 | Synthesis Example 1 |
| | Polymer-2 | Synthesis Example 4 | Synthesis Example 5 | Synthesis Example 21 | Synthesis Example 7 |
| | Curable compound-1 | SLK-1500 | SLK-1500 | SLK-1500 | SLK-1500 |
| | Curable compound-2 | | | | |
| | Initiator | DCP | DCP | DCP | DCP |
| Composition blending ratio | Polymer-1 | 25 | 25 | 25 | 45 |
| | Polymer-2 | 25 | 25 | 25 | 5 |
| | Curable compound-1 | 50 | 50 | 5 | 50 |
| | Curable compound-2 | | | | |
| | Initiator | 1.1 | 1.1 | 1.1 | 1.1 |
| CCL | Resin flow (%) | 15 | 15 | 15 | 20 |
| Composition properties | Loss tangent | 0.0018 | 0.0021 | 0.0017 | 0.0015 |
| | Peel strength (N/mm) | 0.5 | 0.5 | 0.5 | 0.6 |
| | Tg (°C) | 116 | 120 | 120 | 124 |
| | Chemical resistance | ○ | ○ | ○ | ○ |
| | Appearance | ○ | ○ | ○ | ○ |
| | Impregnation test | ○ | ○ | ○ | ○ |

[Table 3-2]

Table 3-2

| | | Example 8 | Example 9 | Example 31 | Example 10 | Example 11 |
|---|---|---|---|---|---|---|
| Composition type | Polymer-1 | Synthesis Example 1 | Synthesis Example 9 | Synthesis Example 22 | Synthesis Example 1 | Synthesis Example 1 |
| | Polymer-2 | Synthesis Example 8 | | | | |
| | Curable compound-1 | SLK-1500 | SLK-1500 | SLK-1500 | SLK-1500 | SLK-1500 |
| | Curable compound-2 | | | | Tufprene 912 | TAIC |
| | Initiator | DCP | DCP | DCP | DCP | DCP |

(continued)

| | | Example 8 | Example 9 | Example 31 | Example 10 | Example 11 |
|---|---|---|---|---|---|---|
| Composition blending ratio | Polymer-1 | 45 | 50 | 50 | 45 | 45 |
| | Polymer-2 | 5 | | | | |
| | Curable compound-1 | 50 | 50 | 50 | 45 | 45 |
| | Curable compound-2 | | | | 10 | 10 |
| | Initiator | 1.1 | 1.1 | 1.1 | 1.1 | 1.1 |
| CCL | Resin flow (%) | 20 | 20 | 20 | 10 | 10 |
| Composition properties | Loss tangent | 0.0013 | 0.0016 | 0.0016 | 0.0016 | 0.0015 |
| | Peel strength (N/mm) | 0.6 | 0.7 | 0.7 | 0.7 | 0.6 |
| | Tg (°C) | 120 | 121 | 125 | 111 | 110 |
| | Chemical resistance | ○ | ○ | ○ | ○ | ○ |
| | Appearance | ○ | ○ | ○ | ○ | ○ |
| | Impregnation test | ○ | ○ | ○ | ○ | ○ |
| | | Comparative Example 1 | Comparative Example 2 | | Comparative Example 18 | |
| Composition type | Polymer-1 | Synthesis Example 10 | Synthesis Example 10 | | SA9000 | |
| | Polymer-2 | | | | | |
| | Curable compound-1 | SLK-1500 | SLK-1500 | | SLK-1500 | |
| | Curable compound-2 | | | | | |
| | Initiator | DCP | DCP | | DCP | |
| Composition blending ratio | Polymer-1 | 50 | 50 | | 50 | |
| | Polymer-2 | | | | | |
| | Curable compound-1 | 50 | 50 | | 50 | |
| | Curable compound-2 | | | | | |
| | Initiator | 1.1 | 1.1 | | 1.1 | |
| CCL | Resin flow (%) | 30 | 30 | | 10.0 | |

(continued)

| | | Comparative Example 1 | Comparative Example 2 | Comparative Example 18 |
|---|---|---|---|---|
| Composition properties | Loss tangent | 0.0020 | 0.0020 | 0.0030 |
| | Peel strength (N/mm) | 0.4 | 0.4 | 0.4 |
| | Tg (°C) | Unmeasurable | Unmeasurable | < 50 |
| | Chemical resistance | X Elution | X Elution | ○ |
| | Appearance | X | X | ○ |
| | Impregnation test | X | X | X |

[Table 4]

Table 4

| | | Example 12 | Example 13 | Example 14 |
|---|---|---|---|---|
| Composition type | Polymer | Synthesis Example 2 | Synthesis Example 2 | Synthesis Example 2 |
| | Curable compound | SLK-1500 | SLK-1500 | SLK-1500 |
| | Additive-1 | Silica particles | Silica particles | |
| | Additive-2 | | | Fluororesin powder |
| | Initiator | DCP | DCP | DCP |
| Composition blending ratio | Polymer | 40 | 15 | 45 |
| | Curable compound | 40 | 15 | 45 |
| | Additive-1 | 20 | 70 | |
| | Additive-2 | | | 10 |
| | Initiator | 1.1 | 1.1 | 1.1 |
| CCL | Resin flow (%) | 10 | 10 | 10 |
| Cured product properties | Loss tangent | 0.0013 | 0.0010 | 0.0013 |
| | Peel strength (N/mm) | 0.5 | 0.4 | 0.5 |
| | Tg (°C) | 120 | 121 | 121 |
| | Chemical resistance | ○ | ○ | ○ |
| | Appearance | ○ | ○ | ○ |
| | Impregnation test | ○ | ○ | ○ |

(continued)

| | | Comparative Example 3 | Comparative Example 4 | Comparative Example 5 | Comparative Example 6 | Comparative Example 7 |
|---|---|---|---|---|---|---|
| Composition type | Polymer | Synthesis Example 10 | Synthesis Example 10 | SA-9000 | Synthesis Example 10 | SA-9000 |
| | Curable compound | SLK-1500 | SLK-1500 | SLK-1500 | SLK-1500 | SLK-1500 |
| | Additive-1 | Silica particles | Silica particles | Silica particles | | |
| | Additive-2 | | | | Fluororesin powder | Fluororesin powder |
| | Initiator | DCP | DCP | DCP | DCP | DCP |
| Composition blending ratio | Polymer | 40 | 15 | 40 | 45 | 45 |
| | Curable compound | 40 | 15 | 40 | 45 | 45 |
| | Additive-1 | 20 | 70 | 70 | | |
| | Additive-2 | | | | 15 | 15 |
| | Initiator | 1.1 | 1.1 | 1.1 | 1.1 | 1.1 |
| CCL | Resin flow (%) | 30 | 30 | 30 | 30 | 10 |
| Cured product properties | Loss tangent | 0.0013 | 0.0020 | 0.0020 | 0.0013 | 0.0020 |
| | Peel strength (N/mm) | 0.3 | 0.2 | 0.1 | 0.3 | 0.1 |
| | Tg (°C) | Unmeasurable | Unmeasurable | < 50 | Unmeasurable | < 50 |
| | Chemical resistance | X Elution | X Elution | ○ | X Elution | ○ |
| | Appearance | X | X | X | X | X |
| | Impregnation test | X | X | - | X | - |

Abbreviations used in Tables 3-1, 3-2, and 4 will be described below.

<Polymer>

· SA-9000: manufactured by SABIC, terminal-modified polyphenylene ether

<Curable Compound>

- SLK-1500: manufactured by Shin-Etsu Chemical Co., Ltd., bismaleimide, number average molecular weight 1500
- TAIC: manufactured by Mitsubishi Chemical Corporation, triallyl isocyanurate
- Tufprene 912: manufactured by Asahi Kasei Corp., styrene-butadiene styrene thermoplastic elastomer

<Other Additives>

- Additive-1: silica particles, ADMAFINE (manufactured by ADMATECHS COMPANY LIMITED, phenylaminosilane-modified particles, particle size 0.4 to 0.6 um)
- Additive-2: fluororesin powder, Fluon+ EA-2000

(manufactured by AGC Inc.)

<Initiator>

· DCP: dicumyl peroxide, manufactured by Tokyo Chemical Industry Co., Ltd.

[Examples 15 to 28 and Comparative Examples 8 to 17]

Each component described in the section of composition type shown in Tables 5 and 6 was mixed with a mix rotor to have the ratio (parts by mass) described in the section of composition blending ratio shown in Tables 5 and 6, and the concentration was adjusted with toluene so that the concentration of the solid content was 30 parts by mass to prepare a composition.

<Resin Flow Evaluation>

Each component described in the section of composition type shown in Tables 5 and 6 was mixed with a mix rotor to have the ratio (parts by mass) described in the section of composition blending ratio shown in Tables 5 and 6, and 67 mass% of toluene was added to 100 mass% of the mixture to prepare a varnish. A glass cloth (Toyobo NE Glass, #1027) was immersed in the prepared varnish for 2 minutes, taken out from the varnish, and then dried at 100°C for 5 minutes and then at 160°C for 10 minutes to prepare a prepreg. A copper foil (TQ-M4-VSP (manufactured by MITSUI MINING & SMELTING CO., LTD., 10 × 10 cm) was overlaid on both surfaces of the prepared prepreg (10 × 10 cm), and vacuum-pressed at room temperature and 3 MPa, then heated to 200°C at 10°C/min, and held at 200°C for 2 hours to prepare a copper-clad laminate (10 × 10 cm). The resin protruding from the prepared copper-clad laminate (10 × 10 cm) was cut out, and the mass of the protruding resin was measured. The resin flow (%) was calculated by the following calculation formula.

$$\text{Resin flow (\%)} = \text{mass of resin protruding after pressing/mass of prepreg} \times 100$$

<Loss Tangent>

The composition obtained in each of Examples 15 to 28 and Comparative Examples 8 to 17 was spin-coated on a 3-inch quartz substrate, dried at 100°C for 5 minutes, and fired at 200°C for 2 hours under nitrogen to prepare a substrate for loss tangent measurement having a cured film formed on the quartz substrate.

The loss tangent at 10 GHz of each of the quartz substrate before coating and the prepared substrate for loss tangent measurement was measured using a cavity resonator method (dielectric constant measurement system TE mode resonator manufactured by AET, Inc.). Based on the obtained results, the loss tangent of each composition was calculated from the following calculation formula. The results are shown in Tables 5 and 6.

When the dielectric constant is designated as Dk1, the loss tangent is designated as Df1, and the thickness of the quartz substrate is designated as t1 in the case of using the quartz substrate; the dielectric constant of the cured film is designated as Dk2, the loss tangent of the cured film is designated as Df2, and the thickness of the cured film is designated as t2; and the dielectric constant is designated as Dk3, the loss tangent is designated as Df3, and the thickness of the substrate for loss tangent measurement is designated as t3 in the case of using the substrate for loss tangent measurement, the dielectric constant (Dk2) and the loss tangent (Df2) of the cured film are calculated by the following calculation formula.

$$Dk2 = [(Dk3 \times t3) - (Dk1 \times t1)]/t2$$

$$Df2 = [(Dk3 \times Df3 \times t3) - (Dk1 \times Df1 \times t1)]/(Dk2 \times t2)$$

<Peel Strength>

The composition obtained in each of Examples 15 to 28 and Comparative Examples 8 to 17 was applied onto a copper foil (CF-V9S-SV-18 (manufactured by FUKUDA METAL FOIL & POWDER CO., LTD.)) having a thickness of 18 um using a baker-type applicator (gap: 12.5 um), and dried at 100°C for 5 minutes and then at 130°C for 5 minutes to form a coating film. A copper foil (CF-V9S-SV-18 (FUKUDA METAL FOIL & POWDER CO., LTD.)) having a thickness of 18 um was overlaid on the formed coating film, pressed under vacuum at 150°C for 5 minutes, and then fired at 200°C for 2 hours under nitrogen to prepare a laminate.

The peel strength was measured using the prepared laminate in the same manner as in, for example, Example 1. The results are shown in Tables 5 and 6.

<Glass Transition Temperature (Tg) and Appearance>

The composition obtained in each of Examples 15 to 28 and Comparative Examples 8 to 17 was applied onto a copper foil (TQ-M4-VSP (manufactured by MITSUI MINING & SMELTING CO., LTD.)) using a baker-type applicator (gap: 75 um), then dried at 100°C for 5 minutes, and fired at 200°C for 2 hours under nitrogen.

The obtained cured film with a copper foil was immersed in a 40 mass% iron chloride solution to remove the copper foil, then washed with water, and dried in an oven at 80°C for 30 minutes to obtain a cured film.

The glass transition temperature (Tg) and appearance were measured and evaluated using the obtained cured film in the same manner as in, for example, Example 1. The results are shown in Tables 5 and 6.

<Chemical Resistance and Impregnation Test>

Chemical resistance and impregnation test were performed in the same manner as in Example 1, except that the compositions obtained in Examples 15 to 28 and Comparative Examples 8 to 17 were used. The results are shown in Tables 5 and 6.

[Table 5]

Table 5

| | | Example 15 | Example 16 | Example 17 | Example 18 | Example 19 | Example 20 | Example 21 |
|---|---|---|---|---|---|---|---|---|
| Composition | Polymer-1 | Synthesis Example 12 | Synthesis Example 12 | Synthesis Example 12 | Synthesis Example 12 | Synthesis Example 12 | Synthesis Example 12 | Synthesis Example 12 |
| | Curable compound-1 | | | | | TAIC | DVB960 | BMI-3000 |
| | Curable compound-2 | | | | | | | BMI-70 |
| | Antioxidant | | Antioxidant-1 | Antioxidant-2 | Antioxidant-3 | | | |
| | Initiator | DCP | DCP | DCP | DCP | DCP | DCP | DCP |
| Composition blending ratio | Polymer-1 | 100 | 100 | 100 | 100 | 70 | 70 | 60 |
| | Curable compound-1 | | | | | 30 | 30 | 30 |
| | Curable compound-2 | | | | | | | 10 |
| | Antioxidant | | 100 ppm | 100 ppm | 100 ppm | | | |
| | Initiator | 0.5 | 0.5 | 0.5 | 0.5 | 0.5 | 0.5 | 3 |
| CCL | Resin flow (%) | 10 | 15 | 15 | 15 | 10 | 10 | 10 |
| Composition properties | Loss tangent | 0.0011 | 0.0011 | 0.0012 | 0.0012 | 0.0012 | 0.0012 | 0.0011 |
| | Peel strength (N/mm) | 0.5 | 0.5 | 0.5 | 0.5 | > 0.6 | > 0.6 | > 0.6 |
| | Tg (°C) | > 130 | > 130 | > 130 | > 130 | > 130 | > 130 | > 130 |
| | Chemical resistance | O | O | O | O | O | O | O |
| | Appearance | O | O | O | O | O | O | O |

(continued)

| | | Example 22 | Example 23 | Example 24 | Example 25 | Example 26 | Example 27 | Example 28 |
|---|---|---|---|---|---|---|---|---|
| Composition | Polymer-1 | Synthesis Example 13 | Synthesis Example 14 | Synthesis Example 15 | Synthesis Example 16 | Synthesis Example 12 | Synthesis Example 12 | Synthesis Example 12 |
| | Curable compound-1 | TAIC | TAIC | TAIC | TAIC | TAIC | TAIC | TAIC |
| | Curable compound-2 | | | | | | | |
| | Antioxidant | | | | | Antioxidant-1 | Antioxidant-2 | Antioxidant-3 |
| | Initiator | DCP | DCP | DCP | DCP | DCP | DCP | DCP |
| Composition blending ratio | Polymer-1 | 70 | 70 | 70 | 70 | 70 | 70 | 70 |
| | Curable compound-1 | 30 | 30 | 30 | 30 | 30 | 30 | 30 |
| | Curable compound-2 | 10 | 10 | 10 | 10 | | | |
| | Antioxidant | | | | | 500 ppm | 500 ppm | 500 ppm |
| | Initiator | 0.5 | 0.5 | 0.5 | 0.5 | 0.5 | 0.5 | 0.5 |
| CCL | Resin flow (%) | 10 | 10 | 20 | 10 | 15 | 15 | 15 |
| Composition properties | Loss tangent | 0.0011 | 0.0012 | 0.0012 | 0.0012 | 0.0011 | 0.0012 | 0.0012 |
| | Peel strength (N/mm) | 0.5 | >0.6 | > 0.6 | > 0.6 | > 0.6 | > 0.6 | > 0.6 |
| | Tg (°C) | > 130 | > 130 | > 130 | > 130 | > 130 | > 130 | > 130 |
| | Chemical resistance | 0 | 0 | 0 | 0 | 0 | 0 | 0 |
| | Appearance | 0 | 0 | 0 | 0 | 0 | 0 | 0 |

[Table 6]

| | | Comparative Example 8 | Comparative Example 9 | Comparative Example 10 | Comparative Example 11 | Comparative Example 12 |
|---|---|---|---|---|---|---|
| Composition | Polymer-1 | Synthesis Example 17 | Synthesis Example 17 | Synthesis Example 17 | Synthesis Example 17 | Synthesis Example 18 |
| | Curable compound-1 | | TA/C | DVB960 | BMI-70 | TAIC |
| | Curable compound-2 | | | | BMI-3000 | |
| | Initiator | DCP | DCP | DCP | DCP | DCP |
| Composition blending ratio | Polymer-1 | 100 | 70 | 70 | 60 | 70 |
| | Curable compound-1 | | 30 | 30 | 30 | 30 |
| | Curable compound-2 | | | | 10 | |
| | Initiator | 0.5 | 0.5 | 0.5 | 3 | 0.5 |
| CCL | Resin flow (%) | 30 | 30 | 30 | 30 | 30 |
| Composition properties | Loss tangent | 0.0040 | 0.0023 | 0.0023 | 0.0023 | 0.0030 |
| | Peel strength (N/mm) | 0.1 | 0.2 | 0.2 | 0.1 | 0.1 |
| | Tg (°C) | Unmeasurable | Unmeasurable | Unmeasurable | Unmeasurable | Unmeasurable |
| | Chemical resistance | X Elution | X Elution | X Elution | X Elution | X Elution |
| | Appearance | X | X | X | X | X |

(continued)

Table 6 (continued)

| | | Comparative Example 13 | Comparative Example 14 | Comparative Example 15 | Comparative Example 16 | Comparative Example 17 |
|---|---|---|---|---|---|---|
| Composition | Polymer-1 | Synthesis Example 19 | SA-9000 | SA-9000 | SA-9000 | SA-9000 |
| | Curable compound-1 | TA/C | | TAIC | DVB960 | BMI-70 |
| | Curable compound-2 | | | | | BMI-3000 |
| | Initiator | DCP | DCP | DCP | DCP | DCP |
| Composition blending ratio | Polymer-1 | 70 | 100 | 70 | 70 | 60 |
| | Curable compound-1 | 30 | | 30 | 30 | 30 |
| | Curable compound-2 | | | | | 10 |
| | Initiator | 0.5 | 0.5 | 0.5 | 0.5 | 3 |
| CCL | Resin flow (%) | 30 | 10 | 10 | 10 | 10 |
| Composition properties | Loss tangent | 0.0030 | 0.0040 | 0.0027 | 0.0027 | 0.0026 |
| | Peel strength (N/mm) | 0.1 | 0.5 | 0.5 | 0.5 | 0.5 |
| | Tg (°C) | Unmeasurable | > 130 | > 130 | > 130 | > 130 |
| | Chemical resistance | X Elution | 0 | 0 | 0 | O |
| | Appearance | X | 0 | 0 | 0 | 0 |

Abbreviations used in Tables 5 and 6 will be described below.

<Polymer>

· SA-9000: manufactured by SABIC, terminal-modified polyphenylene ether

<Curable Compound>

· TAIC: manufactured by Mitsubishi Chemical Corporation, triallyl isocyanurate
· DVB960: manufactured by NIPPON STEEL Chemical & Material CO., LTD., divinylbenzene (divinylbenzene: 96 mass%)
· BMI-3000: manufactured by Designer Molecules Inc., bismaleimide (bifunctional bismaleimide, Mw: about 3000)
· BMI-70: manufactured by K.I Chemical Industry Co., Ltd., bis-(3-ethyl-5-methyl-4-maleimidophenyl)methane

<Antioxidant>

· Antioxidant-1: manufactured by TCI, 2,2,6,6-tetramethyl-4-hydroxypiperidine-1-oxyl
· Antioxidant-2: manufactured by TCI, 3,5-di-tert-4-butylhydroxytoluene
· Antioxidant-3: manufactured by ADEKA CORPORATION, AO-30 (chemical name: 4,4',4"-(1-methylpropanyl-3-ylidene)tris(6-tert-butyl-m-cresol)

<Initiator>

· DCP: dicumyl peroxide, manufactured by Tokyo Chemical Industry Co., Ltd.

## Claims

**1.** A polymer comprising:

a repeating structural unit represented by the following Formula (1); and
a group Y represented by the following Formula (a) at a terminal:

[Chem. 1]

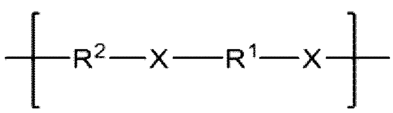

(1)

wherein X's are each independently -O-, -S-, or - N($R^3$)-, $R^3$ is a hydrogen atom, a monovalent hydrocarbon group having 1 to 20 carbon atoms, a monovalent halogenated hydrocarbon group having 1 to 20 carbon atoms, or a group obtained by substituting a part of the hydrocarbon group or the halogenated hydrocarbon group with at least one selected from an oxygen atom and a sulfur atom, $R^1$ is a divalent organic group, and $R^2$ is a divalent unsubstituted or substituted nitrogen-containing heteroaromatic ring;
[Chem. 2]

Y (a)

wherein Y is a group containing an ethylenically unsaturated double bond and having 3 to 50 carbon atoms, an unsubstituted or substituted aromatic hydrocarbon group having 6 to 50 carbon atoms, an unsubstituted or substituted aliphatic hydrocarbon group having 6 to 50 carbon atoms, or an unsubstituted nitrogen-containing heteroaromatic ring, and when the aromatic hydrocarbon group or the aliphatic hydrocarbon group has a substituent, the substituent is a group other than a hydroxy group.

2. The polymer according to claim 1, wherein the divalent organic group represented by $R^1$ in the above Formula (1) comprises a group represented by the following Formula (2-1):

[Chem. 3]

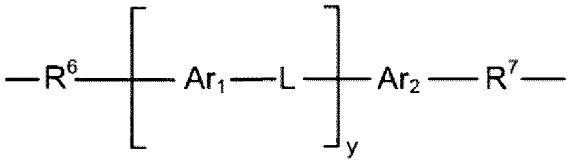

(2-1)

wherein $Ar_1$ and $Ar_2$ are each independently an unsubstituted or substituted aromatic hydrocarbon group, L is a single bond, -O-, -S-, -N($R^8$)-, -C(O)-, -C(O)-O-, -C(O)-NH-, -S(O)-, -S(O)$_2$-, -P(O)-, or a divalent organic group, $R^8$ is a hydrogen atom, a monovalent hydrocarbon group having 1 to 20 carbon atoms, or a monovalent halogenated hydrocarbon group having 1 to 20 carbon atoms, y is an integer of 0 to 5, when y is 2 or more, a plurality of $Ar_1$ and L may be the same as or different from each other, and $R^6$ and $R^7$ are each independently a single bond, a methylene group, or an alkylene group having 2 to 4 carbon atoms.

3. The polymer according to claim 2, wherein $Ar_1$ and $Ar_2$ in the Formula (2-1) are each independently an aromatic hydrocarbon group having an allyl group.

4. The polymer according to any one of claims 1 to 3, wherein a weight average molecular weight of the polymer in terms of polystyrene is 1,000 to 500,000.

5. A composition comprising:

the polymer according to any one of claims 1 to 4; and
a curable compound (B) other than the polymer.

6. The composition according to claim 5, wherein the curable compound (B) comprises at least one selected from the group consisting of a vinyl compound, a maleimide compound, an allyl compound, an acrylic compound, a methacrylic compound, a thiol compound, an oxazine compound, a cyanate compound, an epoxy compound, an oxetane compound, a methylol compound, a benzocyclobutene compound, a propargyl compound, and a silane compound.

7. The composition according to claim 5 or 6, further comprising an antioxidant.

8. A cured product which is a cured product of the composition according to any one of claims 5 to 7.

9. A laminate comprising:

a substrate; and
a cured layer formed using the composition according to any one of claims 5 to 7.

10. An electronic component comprising the cured product according to claim 8 or the laminate according to claim 9.

**INTERNATIONAL SEARCH REPORT**

International application No. **PCT/JP2022/013158**

**A. CLASSIFICATION OF SUBJECT MATTER**

***B32B 27/00***(2006.01)i; ***C08F 299/02***(2006.01)i; ***C08G 65/40***(2006.01)i; ***C08G 73/10***(2006.01)i; ***C08L 71/00***(2006.01)i; ***G03F 7/027***(2006.01)i
FI: C08G65/40; C08L71/00 A; B32B27/00 Z; G03F7/027 511; C08G73/10; C08F299/02

According to International Patent Classification (IPC) or to both national classification and IPC

**B. FIELDS SEARCHED**

Minimum documentation searched (classification system followed by classification symbols)

C08F299; C08G65; C08G73

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2006-117788 A (JAPAN AEROSPACE EXPLORATION AGENCY) 11 May 2006 (2006-05-11)<br>claims, paragraph [0011], examples | 1, 2, 4 |
| X | JP 63-37123 A (MITSUI TOATSU CHEM INC) 17 February 1988 (1988-02-17)<br>claims, p. 2, lower right column, p. 3, upper right column, p. 5, upper right column | 1, 5-10 |
| X | JP 63-118327 A (MITSUI TOATSU CHEM INC) 23 May 1988 (1988-05-23)<br>claims, p. 2, lower right column, p. 3, lower left column, p. 5, lower left column, examples | 1, 2, 4-10 |
| X | JP 62-149723 A (CENTRE D'ETUDE DES MATERIAUX ORGANIQUES POUR TECHNOLOGIES AVANCEES) 03 July 1987 (1987-07-03)<br>claims, p. 3, lower right column, p. 4, upper left column, p. 5, lower left column, examples 2, 11 | 1, 2, 4-10 |
| X | JP 2006-76950 A (ASAHI DENKA KOGYO KK) 23 March 2006 (2006-03-23)<br>claims, paragraphs [0017], [0032]-[0035], [0049], [0066] | 1, 4-10 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 May 2022** | **14 June 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

INTERNATIONAL SEARCH REPORT

International application No.
PCT/JP2022/013158

C. DOCUMENTS CONSIDERED TO BE RELEVANT

| Category* | Citation of document, with indication, where appropriate, of the relevant passages | Relevant to claim No. |
|---|---|---|
| X | JP 2017-197725 A (JSR CORP) 02 November 2017 (2017-11-02)<br>claims, paragraphs [0001], [0002], examples 1-24 | 1, 2, 4-10 |
| X | JP 2017-200997 A (JSR CORP) 09 November 2017 (2017-11-09)<br>claims, paragraphs [0007], [0129], [0168], [0176], examples | 1, 2, 4-10 |
| X<br><br>Y | WO 2009/098791 A1 (DAIWA CAN COMPANY) 13 August 2009 (2009-08-13)<br>claims, paragraphs [0002], [0003], [0046] | 1, 2, 4, 7<br><br>5, 6, 8-10 |
| Y | JP 2009-260232 A (HITACHI CHEMICAL CO LTD) 05 November 2009 (2009-11-05)<br>claims | 5, 6, 8-10 |
| Y | JP 2015-147907 A (HITACHI CHEM DUPONT MICROSYS) 20 August 2015 (2015-08-20)<br>claims | 5, 6, 8-10 |
| Y | JP 2014-215440 A (HITACHI CHEMICAL CO LTD) 17 November 2014 (2014-11-17)<br>claims | 5, 6, 8-10 |
| X | FR 1527714 A (INSTITUT FRANCAIS DU PETROLE, DES CARBURANTS ET LUBRIFIANTS) 07 June 1968 (1968-06-07)<br>claims, p. 1 | 1, 2, 4 |
| X | SU 204571 A (U.S.S.R.) 20 October 1967 (1967-10-20), pp. 1-2, CAS Registry no. DN 69:3443<br>p. 1 | 1-10 |
| A | JP 2001-2949 A (ASAHI DENKA KOGYO KK) 09 January 2001 (2001-01-09)<br>entire text | 1-10 |
| A | JP 53-47496 A (KANEGAFUCHI CHEM IND) 27 April 1978 (1978-04-27)<br>entire text | 1-10 |
| A | JP 63-117034 A (CENTRE D'ETUDE DES MATERIAUX ORGANIQUES POUR TECHNOLOGIES AVANCEES) 21 May 1988 (1988-05-21)<br>entire text | 1-10 |
| A | WO 2010/027020 A1 (KANEKA CORP) 11 March 2010 (2010-03-11)<br>entire text | 1-10 |
| P, X | WO 2021/079977 A1 (NISSAN CHEMICAL CORP) 29 April 2021 (2021-04-29)<br>entire text | 1, 2, 4-10 |
| P, X | WO 2021/187481 A1 (NISSAN CHEMICAL CORP) 23 September 2021 (2021-09-23)<br>entire text | 1-10 |

Form PCT/ISA/210 (second sheet) (January 2015)

INTERNATIONAL SEARCH REPORT
Information on patent family members

International application No.
PCT/JP2022/013158

| Patent document cited in search report | Publication date (day/month/year) | Patent family member(s) | Publication date (day/month/year) |
|---|---|---|---|
| JP 2006-117788 A | 11 May 2006 | (Family: none) | |
| JP 63-37123 A | 17 February 1988 | US 4803258 A<br>claims, column 1, line 65 to column 2, line 4, column 4, lines 23-26, column 9, lines 49-59<br>EP 255778 A1<br>KR 10-1988-0002913 A | |
| JP 63-118327 A | 23 May 1988 | US 4803258 A<br>claims, column 1, line 65 to column 2, line 4, column 4, lines 23-26, column 9, lines 49-59, examples<br>EP 255778 A1<br>KR 10-1988-0002913 A | |
| JP 62-149723 A | 03 July 1987 | US 4764578 A<br>claims, column 1, lines 20-25, column 1, lines 29-33, column 3, lines 32-36, examples 2, 11<br>EP 220080 A1<br>FR 2587348 A1 | |
| JP 2006-76950 A | 23 March 2006 | (Family: none) | |
| JP 2017-197725 A | 02 November 2017 | US 2019/0055357 A1<br>claims, paragraphs [0001], [0002], examples 1-24<br>WO 2017/183461 A1<br>EP 3447081 A1<br>TW 201807017 A<br>CN 109071804 A<br>KR 10-2018-0136950 A | |
| JP 2017-200997 A | 09 November 2017 | US 2019/0055357 A1<br>claims, paragraphs [0020], [0239], [0278], [0290], examples<br>WO 2017/183461 A1<br>EP 3447081 A1<br>TW 201807017 A<br>CN 109071804 A<br>KR 10-2018-0136950 A | |
| WO 2009/098791 A1 | 13 August 2009 | US 2011/0003955 A1<br>claims, paragraphs [0002], [0003], [0053]<br>EP 2246383 A1<br>CN 102015834 A<br>TW 200934808 A | |
| JP 2009-260232 A | 05 November 2009 | (Family: none) | |
| JP 2015-147907 A | 20 August 2015 | (Family: none) | |
| JP 2014-215440 A | 17 November 2014 | (Family: none) | |
| FR 1527714 A | 07 June 1968 | (Family: none) | |
| JP 2001-2949 A | 09 January 2001 | (Family: none) | |
| JP 53-47496 A | 27 April 1978 | (Family: none) | |
| JP 63-117034 A | 21 May 1988 | US 4814403 A | |

Form PCT/ISA/210 (patent family annex) (January 2015)

**INTERNATIONAL SEARCH REPORT**
**Information on patent family members**

International application No.
**PCT/JP2022/013158**

| Patent document cited in search report | Publication date (day/month/year) | Patent family member(s) | Publication date (day/month/year) |
|---|---|---|---|
| | | whole document<br>EP 267076 A1<br>FR 2605010 A1 | |
| WO 2010/027020 A1 | 11 March 2010 | US 2011/0165809 A1<br>whole document<br>EP 2333004 A1<br>CN 102143989 A | |
| WO 2021/079977 A1 | 29 April 2021 | (Family: none) | |
| WO 2021/187481 A1 | 23 September 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H07188362 A
- JP 2004083680 A
- JP 3414556 B
- JP 2003306591 A
- JP 5649773 B
- JP 2017200997 A
- JP 2006178059 A
- JP 2012226297 A
- JP 2005060507 A


### Non-patent literature cited in the description


- *CHEMICAL ABSTRACTS,* 2516-92-9